(19) Europäisches Patentamt
European Patent Office
Office européen des brevets

(11) EP 1 254 874 A1

(12) **EUROPEAN PATENT APPLICATION**
published in accordance with Art. 158(3) EPC

(43) Date of publication:
06.11.2002 Bulletin 2002/45

(21) Application number: 00913091.5

(22) Date of filing: 04.04.2000

(51) Int Cl.$^7$: **C04B 35/581**

(86) International application number:
**PCT/JP00/02165**

(87) International publication number:
**WO 01/047831 (05.07.2001 Gazette 2001/27)**

(84) Designated Contracting States:
**AT BE CH CY DE DK ES FI FR GB GR IE IT LI LU MC NL PT SE**

(30) Priority: 28.12.1999 JP 37216399
28.12.1999 JP 37216499
28.12.1999 JP 37216599
28.12.1999 JP 37216699

(71) Applicant: **Ibiden Co., Ltd.**
**Ogaki-shi, Gifu 503-0917 (JP)**

(72) Inventors:
• **HIRAMATSU, Yasuji**
**Ibi-gun, Gifu 501-0695 (JP)**
• **ITO, Yasutaka**
**Ibi-gun, Gifu 501-0695 (JP)**

(74) Representative: **Müller-Boré & Partner**
**Patentanwälte**
**Grafinger Strasse 2**
**81671 München (DE)**

(54) **CARBON-CONTAINING ALUMINUM NITRIDE SINTERED COMPACT, AND CERAMIC SUBSTRATE FOR USE IN APPARATUS FOR MANUFACTURING AND INSPECTING SEMICONDUCTOR**

(57) An object of the present invention is to provide a carbon-containing aluminum nitride sintered body wherein no short circuit is caused since its volume resistivity at a high temperature range of 200 °C or higher (for example, about 500 °C) is sufficiently high, that is, at least $1 \times 10^8$ Ω • cm or more, and also wherein covering-up capability, a large radiant heat amount and measurement accuracy with a thermoviewer can be assured. The carbon-containing aluminum nitride sintered body of the present invention is comprising carbon whose peaks appear near 1580cm$^{-1}$ and near 1355 cm$^{-1}$ in laser Raman spectral analysis in a matrix made of aluminum nitride.

Fig. 1

EP 1 254 874 A1

## Description

Technical Field

The present invention relates to an aluminum nitride sintered body used as a constituting material of a hot plate, an electric static chuck, a wafer prober, a susceptor and the like mainly in the semiconductor industry; and relates particularly to a carbon-containing aluminum nitride sintered body superior in capability of covering up an electrode pattern and so on, volume resistivity at high temperature, and accuracy of temperature-measurement with a thermoviewer.

The present invention also relates to a ceramic substrate, wherein a ceramic made of the above-mentioned aluminum nitride sintered body or the like is used, the ceramic substrate being used as a semiconductor producing or examining device such as a hot plate, an electrostatic chuck or a wafer prober; and relates particularly to a ceramic substrate, for a semiconductor producing/examining device, which is superior in capability of covering up an electrode pattern and so on, volume resistivity at high temperature, and accuracy of temperature-measurement with a thermoviewer.

Background Art

Hitherto, a heater, a wafer prober or the like, using a metal base material such as stainless steel or aluminum alloy, has been used in semiconductor producing or examining devices comprising an etching device, a chemical vapor deposition device and the like.

However, a heater made of a metal has problems that its temperature controllability is poor and its thickness also becomes thick so that the heater is heavy and bulky. The heater also has a problem that corrosion resistance against corrosive gas is poor.

To solve these problems, JP Kokai Hei 11-40330 discloses a heater wherein a ceramic such as aluminum nitride is used instead of a metal.

However, aluminum nitride itself, which is a base material constituting this heater, is generally white or light gray; therefore, it is not preferred for the use of a heater or a susceptor. Whereas, color of black has a larger radiant heat amount, therefore it is suitable for such a kind of use. Color of black is particularly preferred for a wafer prober or an electrostatic chuck since it has a high capability of covering up an electrode pattern. Furthermore, when the surface temperature of a heater is measured with a thermoviewer (surface thermometer) , in the case of the substrate being white or light gray, the radiant heat thereof is also measured together by a thermoviewer so that accurate measurement of the temperature has been impossible.

In inventions in the prior art which are disclosed in JP Kokai Hei 9-48668 and the like, which are developed to comply with such a demand. is suggested a ceramic base material to which, crystalline carbon whose peak is detected at a position of 44 to 45° in its X-ray diffraction chart, is added.

Summary of the Invention

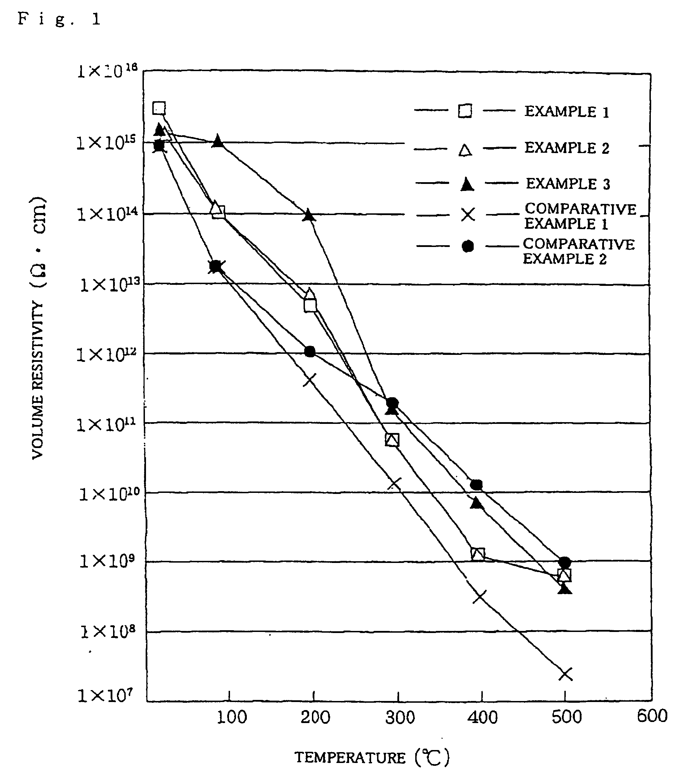

However, the ceramic base material in the prior art, to which such crystalline carbon (graphite) is added, has the following problem: in the case that the ceramic substrate is a ceramic substrate inside which resistance heating elements and so on are equipped, a short circuit is caused since its volume resistivity drops down below $1 \times 10^8 \, \Omega \cdot$ cm at high temperature, for example, at a high temperature range of 200 °C or higher (see FIG. 1).

An object of the present invention is to solve the problems that the above-mentioned prior art embraces and provide an aluminum nitride sintered body wherein no short circuit is caused since its volume resistivity, particularly at a high temperature range of 200 °C or higher (for example, about 500 °C), is sufficiently high, that is, at least $1 \times 10^8$ $\Omega \cdot$ cm or more, and covering-up capability, a large radiant heat amount and accuracy of temperature-measurement with a thermoviewer can be assured.

Another object of the present invention is to provide a ceramic substrate for a semiconductor producing/ examining device, which is useful for a hot plate, an electrostatic chuck, a wafer prober or a susceptor, wherein no short circuit is caused since its volume resistivity, particularly at a high temperature range of 200 °C or higher (for example, about 500 °C), is sufficiently high, that is, at least $1 \times 10^8 \, \Omega \cdot$ cm or more, and wherein covering-up capability, a large radiant heat amount and measurement accuracy with a thermoviewer can be assured.

The aluminum nitride of the present invention has been developed to comply with the above-mentioned demand, and is particularly comprising carbon whose peaks appear near 1580cm$^{-1}$ and near 1355 cm$^{-1}$ in laser Raman spectral analysis in a matrix made of aluminum nitride.

The carbon-containing nitride aluminum sintered body may comprise carbon whose peak intensity ratio I (1580)/I(1355), which is the ratio of the peak near 1580 cm$^{-1}$ to the peak near 1355 cm$^{-1}$, is 3.0 or less; or may comprise carbon whose peak intensity ratio is over 3.0. Which of the sintered bodies to be adopted should be decided by required properties, as described below, for the sintered body.

The half-width (full width at half maximum) of the peak near 1355 cm$^{-1}$ is preferably 20 cm$^{-1}$ or more, and the content of the above-mentioned carbon is preferably 200 to 5000 ppm.

The carbon-containing aluminum nitride sintered body preferably comprises a sintering aid comprising at least one of alkali metal oxides, alkali earth metal oxides and rare earth element oxides. The color of the sintered body is preferably N4 or less according to the brightness defined in JIS Z 8721.

The ceramic substrate for a semiconductor producing/examining device according to the present invention is also the one wherein the ceramic substrate which is comprising carbon whose peaks appear near 1580cm$^{-1}$ and near 1355 cm$^{-1}$ in laser Raman spectral analysis is equipped with a conductor.

The above-mentioned ceramic substrate for a semiconductor producing/examining device may comprise carbon whose peak intensity ratio I(1580)/I(1355), which is the ratio of the peak near 1580 cm$^{-1}$ to the peak near 1355 cm$^{-1}$, is 3.0 or less; or may comprise carbon whose peak intensity ratio is over 3.0. Which of the sintered bodies to be adopted should be decided by required properties, as described below, for the sintered body.

In the above-mentioned ceramic substrate for a semiconductor producing/examining device, the half-width (full width at half maximum) of the peak near 1355 cm$^{-1}$ is preferably 20 cm$^{-1}$ or more.

In the above-mentioned ceramic substrate for a semiconductor producing/examining device, the conductor may be an electrostatic electrode, and the ceramic substrate desirably functions as an electrostatic chuck; or the conductor may be a resistance heating element, and the ceramic substrate desirably functions as a hot plate.

Desirably, the conductor is formed on a surface of the ceramic substrate or inside the ceramic substrate and the inner conductor is at least any one of a guard electrode and/or a ground electrode, and the ceramic substrate functions as a wafer prober.

Desirably, in the above-mentioned ceramic substrate for a semiconductor producing/examining device, carbon whose peaks appear near 1580cm$^{-1}$ and near 1355 cm$^{-1}$ in laser Raman spectral analysis is amorphous carbon and the content of the carbon is 200 to 5000 ppm.

Desirably, the above-mentioned ceramic substrate for a semiconductor producing/examining device comprises a sintering aid made of at least one of alkali metal oxides, alkali earth metal oxides and rare earth element oxides and has a brightness defined in JIS Z 8721 of N4 or less.

Brief Description of Drawings

FIG. 1 is a graph showing relationship between the temperatures of Aluminum nitride sintered bodies in Examples 1 to 3 and Comparative Examples 1 and 2 and the volume resistivities thereof.

FIG. 2 is a laser Raman spectrum showing a result of laser Raman spectral analysis of carbon in the aluminum nitride sintered body obtained in Example 1.

FIG. 3 is a laser Raman spectrum showing a result of laser Raman spectral analysis of carbon in the aluminum nitride sintered body obtained in Example 2.

FIG. 4(a) is a vertical sectional view illustrating an electrostatic chuck schematically, and FIG. 4(b) is a sectional view, taken along A-A line, of the electrostatic chuck shown in FIG. 4(a) .

FIG. 5 is a horizontal sectional view schematically illustrating another example of electrostatic electrodes embedded in the electrostatic chuck.

FIG. 6 is a horizontal sectional view that schematically illustrates a further example of electrostatic electrodes embedded in the electrostatic chuck.

FIG. 7 is a bottom plain view that schematically illustrates a ceramic heater, which is an example of the ceramic substrate for a semiconductor producing/examining device of the present invention.

FIG. 8 is a partially enlarged sectional view that schematically illustrates the ceramic heater illustrated in FIG. 7.

FIG. 9 is a graph showing dependency of bending strengths of the aluminum nitride sintered bodies in Examples 1 and 3 on temperature.

FIG. 10 is a laser Raman spectrum showing a result of laser Raman spectral analysis of carbon in the aluminum nitride sintered body obtained in Comparative Example 1.

FIG. 11 is a graph showing dependency of thermal conductivities of the aluminum nitride sintered bodies in Examples 1 and 3 on temperature.

FIG. 12 is a laser Raman spectrum showing a result of laser Raman spectral analysis of carbon in the aluminum nitride sintered body obtained in Example 3.

FIG. 13 is a laser Raman spectrum showing a result of laser Raman spectral analysis of carbon in the aluminum nitride sintered body obtained in Example 6.

FIG. 14 is a sectional view that schematically illustrates a wafer prober, which is an example of the ceramic substrate for a semiconductor producing/examining device of the present invention.

FIG. 15 is a plain view that schematically illustrates the wafer prober illustrated in FIG. 14.

FIG. 16 is a sectional view, taken along A-A line, of the wafer prober illustrated in FIG. 14

FIG. 17 is an explanatory view of steps of producing a wafer prober having a ceramic substrate made of an aluminum nitride sintered body.

FIG. 18 is an explanatory view of steps of producing the wafer prober having the ceramic substrate made of the aluminum nitride sintered body.

FIG. 19 is a graph showing relationship between the temperatures of aluminum nitride sintered bodies in Examples 7 to 9 and the volume resistivities thereof.

FIG. 20 is a graph showing the effect of the thermal conductivities of the aluminum nitride sintered bodies in Examples 7 and 9.

FIG. 21 is a laser Raman spectrum showing a result of laser Raman spectral analysis of carbon in the aluminum nitride sintered body obtained in Example 7.

FIG. 22 is a laser Raman spectrum showing a result of laser Raman spectral analysis of carbon in the aluminum nitride sintered body obtained in Example 8.

FIG. 23 is a laser Raman spectrum showing a result of laser Raman spectral analysis of carbon in the aluminum nitride sintered body obtained in Example 9.

FIG. 24 is a graph showing relationship between the temperature of a ceramic substrate component in Example 19 and the volume resistivity thereof.

Explanation of Symbols

2 chuck top conductor layer
3 aluminum nitride substrate (ceramic substrate)
5 guard electrode
6 ground electrode
7 groove
8 air suction hole
16,17 plated through hole
19, 190, 191 external terminal pin
20, 70, 80 electrostatic chuck
21, 71, 81 aluminum nitride substrate
22, 72, 82a, 82b chuck positive electrostatic layer
23, 73, 83a, 83b chuck negative electrostatic layer
41 resistance heating element
180 blind hole

Detailed Disclosure of the Invention

Research by the inventors demonstrated that there were cases that a short circuit was caused between its resistance heating element patterns or between its electrode patterns at the time of heating a ceramic substrate made of an aluminum nitride sintered body comprising crystalline carbon whose peak was detected at a position of $2\theta = 44$ to 45°, since its volume resistivity at high temperature (for example, 200 °C or higher) was greatly lowered.

The reason for this can be considered as follows. The volume resistivity of an aluminum nitride sintered body is lowered at high temperature and further crystalline carbon has a crystal structure similar to metal crystal and a large electric conductivity at high temperature. Therefore, the two properties act synergistically so that such a short circuit as above is caused.

Thus, the inventors made further research to obtain a sintered body having a large volume resistivity making it possible to prevent such a short circuit. As a result, the inventors have found that in order to increase the volume resistivity of carbon at high temperature, carbon with lowered crystallinity wherein peaks are detected at both positioned near 1580 $cm^{-1}$ and near 1355 $cm^{-1}$ in laser Raman spectral analysis should be used, and have completed the present invention. In the present invention, peaks include halos. The wording "near 1580 $cm^{-1}$" and "near 1355 $cm^{-1}$" are used, considering the error of Raman shifts, and mean peaks showing their appearance near 1580 $cm^{-1}$ and near 1355 $cm^{-1}$.

The following will first describe laser Raman spectral analysis of carbon material.

A Raman spectrum means a spectrum of scattered light showing its appearance by Raman effect. This Raman effect means the phenomenon that when monochromatic light having a specific frequency is radiated on a material, scattered light includes light having a wavelength different from that of the radiated light.

When laser light having a given wavelength is radiated on carbon material, the Raman effect is caused so that a laser Raman spectrum is observed. Since this Raman spectrum is light generated in relation to crystal vibration and so on, it is possible to detect the spectrum having a wavelength depending on the crystallinity of the material.

Specifically, in crystalline carbon (graphite and so on) , a spectrum is detected near 1580 cm$^{-1}$. Alternatively, if a part of the crystal lattice of the crystalline carbon is amorphous or amorphous carbon is incorporated into crystalline carbon, a peak is detected even near 1355 cm$^{-1}$. Therefore, it can be said that carbon whose peaks are detected at both positions near 1580 cm$^{-1}$ and near 1355 cm$^{-1}$ is carbon having relatively low crystallinity.

As the peak intensity ratio I(1580)/I(1355) , which is the ratio of the peak near 1580 cm$^{-1}$ to the peak near 1355 cm$^{-1}$ is larger, the crystallinity is higher.

The peak near 1355 cm$^{-1}$ represents amorphousness, and the amorphous nature is higher as the half-width (full width at half maximum) of this is larger.

As described above, in the aluminum nitride sintered body of the present invention, carbon having both natures of crystal and amorphousness is incorporated to suppress a drop in the volume resistivity of the aluminum nitride sintered body in a high temperature range of 200 °C or higher. Thus, a short circuit in inner resistance heating elements and so on is prevented and further the aluminum nitride sintered body is blackened.

The specific method for obtaining an aluminum nitride sintered body comprising carbon whose peaks are detected near 1580 cm$^{-1}$ and near 1355 cm$^{-1}$ in laser Raman spectral analysis is not particularly limited, but the following methods are preferred.

Specifically, an acrylic resin having an acid value of 5 to 17 KOHmg/g is mixed with a ceramic raw material, and the resultant is formed. Thereafter, at a temperature of 350 °C or higher in an inert gas atmosphere (nitrogen gas or argon gas), the formed body is decomposed, carbonized, and thermally-decomposed. After the thermal decomposition, the body is heated and pressed to prepare an aluminum nitride sintered body . Carbon resulting from the thermal decomposition of such an acrylic resin tends to have low crystallinity, and tends to have a peak intensity ratio I(1580) /I(1355) of 3.0 or lower.

The reason why the crystallinity becomes low by using such an acrylic resin is unclear. However, since an acrylic resin having an acid value of 5 to 17 KOHmg/g is not easily thermally-decomposed nor carbonized, it is presumed that carbonization advances with the amorphous frame of the acrylic resin being remained. Since the acrylic resin having an acid value of 5 to 17 KOHmg/g is not easily thermally-decomposed, the blend ratio thereof is desirably adjusted into 2.5 to 8 % by weight of raw material powder. The acrylic resin having an acid value of 5 to 17 KOHmg/g desirably has a Tg point of - 30 °C to -10 °C. The weight-average molecular weight thereof is desirably from 10000 to 50000.

Besides this, there may be used a method of mixing an acrylic resin having an acid value of 0.3 to 1.0 KOHmg/g with a ceramic raw material, forming this mixture, and decomposing, carbonizing and thermally-decomposing the formed body at a temperature of 350 °C or higher in an inert gas atmosphere (nitrogen gas or argon gas) . After the thermal decomposition, the body is heated and pressed to prepare an aluminum nitride sintered body.

Carbon resulting from the thermal decomposition of such an acrylic resin tends to have both natures of crystal and amorphousness, and tends to have a peak intensity ratio I(1580)/I(1355) over 3.0.

The reason why carbon having both natures of crystal and amorphousness is obtained by using such an acrylic resin is unclear. However, since an acrylic resin having an acid value of 0.3 to 1.0 KOHmg/g is easily thermally-decomposed or carbonized, it is presumed that carbonization advances with the amorphous frame of the acrylic resin being cut; therefore, the crystallinity becomes high easily. Since the acrylic resin having an acid value of 0.3 to 1.0 KOHmg/g is easily thermally-decomposed, the blend ratio thereof is desirably adjusted into 8 to 20 % by weight of raw material powder. The acrylic resin having an acid value of 0.3 to 1.0 KOHmg/g desirably has a Tg point of 40 °C to 60 °C. The weight-average molecular weight thereof is desirably from 10000 to 50000.

The acrylic resin is desirably a copolymer comprising one or more of acrylic acid and an ester of acrylic acid and/or one or more of methacrylic acid and a methacrylic ester.

A commercially available product of such an acrylic resin may be KC-600 series made by Kyoeisyha Chemical Co., Ltd. The available acid value of this series is from 10 to 17 KOHmg/g.

SA-545 series made by Mitsui Chemicals, Inc. may be commercially available. The available acid value of this series is from 0.5 to 1.0 KOHmg/g.

The carbon-containing aluminum nitride sintered body of the present invention is a sintered body containing a carbon whose peaks are detected near 1580cm$^{-1}$ and near 1355 cm$^{-1}$ in laser Raman spectral analysis thereof and having a new physical property that its volume resistivity at 25 to 500 °C is $1 \times 10^8$ Ω • cm or more. Therefore, the novelty and the inventive step of the present invention are not rejected on the basis of the prior art, for example, Japanese Patent Publication No. Hei 9-48668.

Japanese Patent Publication No. Hei 9-48668 states that graphite may be used. But with crystalline graphite, a peak appears only at 1580 cm$^{-1}$ in its laser Raman spectrum. In Japanese Patent Publication No. Hei 9-48668, the graphite is considered to be the one having high crystallinity by the analysis of an X-ray diffraction. Therefore, the present invention is entirely different from the invention of Japanese Patent Publication No. Hei 9-48668.

In the carbon-containing aluminum nitride sintered body of the present invention, the peak intensity ratio I (1580)/I(1355), which is the ratio of the peak near 1580 cm$^{-1}$ to the peak near 1355 cm$^{-1}$ in laser Raman spectral analysis, may be 3.0 or less. If the peak intensity ratio I(1580)/I(1355) is 3.0 or less, the percentage of contained crystalline carbon is small. Therefore, in a high temperature range of 200 °C or higher, a high volume resistivity can be sufficiently kept.

In the carbon-containing aluminum nitride sintered body of the present invention, the peak intensity ratio I (1580)/I(1355) which is the ratio of the peak near 1580 cm$^{-1}$ to the peak near 1355 cm$^{-1}$ in laser Raman spectral analysis, may be over 3.0. If the peak intensity ratio I(1580)/I(1355) is over 3.0, the percentage of contained crystalline carbon is large. Therefore, a high fracture toughness (2.5 MPam$^{1/2}$ or more) can be kept. The reason why a high fracture toughness can be kept is unclear, but it is presumed that development of cracks is suppressed by carbon having high crystallinity.

In the case that a drop in the thermal conductivity at high temperature has to be suppressed, the peak intensity ratio I(1580)/I(1355) is preferably 1.0 or more. If the peak intensity ratio I(1580)I(1355) is below 1.0, the degree of the amorphousness is large and the thermal conductivity at high temperature drops. The reason why the thermal conductivity drops if the peak intensity ratio I(1580)/I(1355) is too low is unclear, but it is presumed that probably amorphous carbon lies in the boundaries of grains to become a barrier blocking the conduction of heat. If the peak intensity ratio I(1580)/I(1355) is over 3.0, a high thermal conductivity of 60 W/m • k or more can be kept in the high temperature region.

Conversely, in the case that the volume resistivity at high temperature has to be lowered, the peak intensity ratio I(1580)/I(1355) is desirably set to less than 1.0.

In short, the peak intensity ratio of the aluminum nitride sintered body is adjusted according to the use thereof.

In the carbon-containing aluminum nitride sintered body of the present invention, it is desired that peaks appear near 1580 cm$^{-1}$ and near 1355 cm$^{-1}$ in laser Raman spectral analysis, and the half-width (full width at half maximum) of the peak near 1355 cm$^{-1}$ is 20 cm$^{-1}$ or more. If the half-width (full width at half maximum) of the peak near 1355 cm$^{-1}$ is less than 20 cm$^{-1}$,

the crystallinity is high so that in some cases a drop in the volume resistivity in a high temperature range of 200 °C or higher cannot be sufficiently suppressed. The half-width of the peak near 1355 cm$^{-1}$ is more desirably 40 cm$^{-1}$ or more and is optimally 45 cm$^{-1}$ or more.

In the carbon-containing aluminum nitride sintered body of the present invention, it is desired that the content of carbon whose peaks appear near 1580 cm$^{-1}$ and near 1355 cm$^{-1}$ in laser Raman spectral analysis is from 200 to 5000 ppm. If the content is below 200 ppm, the sintered body is not black and has a brightness of more than N4. On the other hand, the added amount is over 5000 ppm, the sinterability of aluminum nitride drops.

In the carbon-containing aluminum nitride sintered body of the present invention, it is desired that the aluminum nitride sintered body constituting its matrix comprises a sintering aid. The sintering aid that can be used may be an alkali metal oxide, an alkali earth metal oxide or a rare element oxide, and is particularly preferably CaO, $Y_2O_3$, $Na_2O$, $Li_2O$ or $Rb_2O$. The content of the sintering aid is desirably from 0.1 to 10 % by weight. Also, alumina may be added.

In the aluminum nitride sintered body of the present invention, its brightness is desirably N4 or less as the value based on the rule of JIS Z 8721. This is because the sintered body having such a brightness is superior in radiant heat amount and covering-up ability. The surface temperature of such a sintered body can be accurately measured with a thermoviewer.

The brightness N is defined as follows: the brightness of ideal black is made to 0; that of ideal white is made to 10; respective colors are divided into 10 parts in the manner that the brightness of the respective colors is recognized stepwise between the brightness of black and that of white at equal intensity intervals; and the resultant parts are indicated by symbols NO to N10, respectively.

Actual brightness is measured by comparison with color cards corresponding to N0 to N10. One place of decimals in this case is made to 0 or 5.

The porosity of the aluminum nitride sintered body of the present invention is desirably 0, or not more than 5 %.

This is because it is possible to suppress a drop in the thermal conductivity at high temperature and generation of warps. The porosity is measured by Archimedes' method.

The following will describe an example of the process for producing an aluminum nitride sintered body of the present invention.

(1) An acrylic resin having an acid'value of 5 to 17 KOHmg/g is mixed with aluminum nitride powder, which will be a matrix component. About the size of the powder to be mixed, its average diameter is preferably from about 0.1 to about 5 μm. This is because as the powder is finer, the sinterability thereof is more improved. Carbon is added, considering the amount of carbon lost when the mixture is fired.

A sintering aid such as the above-mentioned yttrium oxide (yttria: $Y_2O_3$) may be added to the mixture.

(2) Next, the resultant powder mixture is put into a mold to prepare a formed body. This formed body is thermally decomposed at 350 °C or higher to carbonize the acrylic resin.

Instead of the processing of the steps (1) and (2), it is allowable to mix aluminum nitride powder, an acrylic resin having an acid value of 5 to 17 KOHmg/g, and a solvent to produce green sheets; laminate the green sheets; and pre-sinter the lamination of the green sheets at 300 to 600 °C to prepare carbon used in the present invention. The solvent that can be used may be α-terpineol, glycol or the like.

(3) Next, the formed body resulting from the carbonization of the acrylic resin or the lamination of the green sheets (which has been pre-sintered) is heated and pressured at 1500 to 1900 °C and 80 to 200 kg/cm$^2$ in an inert gas atmosphere of argon, nitrogen or the like so as to be sintered.

As the sintering temperature is close to 1900 °C, the crystallinity of carbon is higher so that the peak intensity ratio I(1580)/I(1355) is larger. Thus, the peak intensity ratio can be adjusted by the sintering temperature.

In the case that an acrylic resin having an acid value of 0.3 to 1.0 KOHmg/g is used instead of the acrylic resin having an acid value of 5 to 17 KOHmg/g, the aluminum nitride sintered body of the present invention can be produced in the same way.

The aluminum nitride sintered body of the present invention can be made to a ceramic heater, a substrate of which is the aluminum nitride sintered body; by embedding metal plates , metal wires or the like, which will be resistance heating elements, in the powder mixture when the powder mixture is put into the mold; or by forming a conductor containing paste layer, which will be resistance heating elements, on one green sheet among the laminated green sheets which will be laminated.

Also, resistance heating elements may be formed on the bottom surface by forming a conductor containing paste layer on the surface (bottom surface) of the sintered body after the production of the sintered body, and then firing the paste.

Furthermore, when this ceramic heater is produced, a hot plate, an electrostatic chuck, a wafer prober, a susceptor or the like can be produced by embedding metal plates or the like in the formed body, or by forming a conductor containing paste on the green sheet to have a shape of resistance heating elements or electrodes of an electrostatic chuck and so on.

The conductor containing paste for producing various electrodes or resistance heating element is not particularly limited, and is preferably a paste comprising not only metal particles or a conductive ceramic for keeping electrical conductivity but also a resin, a solvent, a thickener and so on.

The metal particles are preferably made of, for example, a noble metal (gold, silver, platinum and palladium), lead, tungsten, molybdenum, nickel or the like. These may be used alone or in combination of two or more. These metals are not relatively easily oxidized, and have an ohmic value sufficient for generating heat.

Examples of the conductive ceramic include carbides of tungsten and molybdenum. These may be used alone or in combination of two or more.

The particle diameter of these metal particles or the conductive ceramic is preferably 0.1 to 100 μm. If the particle diameter is too fine, that is, below 0.1 μm, they are easily oxidized. On the other hand, if the particle diameter is over 100 μm, they are not easily sintered so that the ohmic value becomes large.

The shape of the metal particles is spherical or scaly. When these metal particles are used, they may be a mixture of spherical particles and scaly particles.

In the case that the metal particles are scaly or a mixture of spherical particles and scaly particles, oxides between the metal particles are easily retained and adhesiveness between the heating elements 12 and the ceramic such as nitride is made sure. Moreover, the ohmic value can be made large. Thus, this case is profitable.

Examples of the resin used in the conductor containing paste include epoxy resins and phenol resins. An example of the solvent is isopropyl alcohol. An example of the thickener is cellulose.

When the conductor containing paste for the resistance heating elements is formed on the surface of the sintered body, it is desired to add a metal oxide besides the metal particles to the conductor containing paste and sinter the metal particles and the metal oxide. By sintering the oxide together with the metal particles in this way, the aluminum nitride sintered body can be closely adhered to the metal particles.

The reason why the adhesiveness to the aluminum nitride sintered body is improved by mixing the metal oxide is unclear, but would be based on the following. The surface of the metal particles or the surface of the aluminum nitride sintered body is slightly oxidized so that an oxidized film is formed. These oxidized films are sintered and integrated with each other through the metal oxide so that the metal particles and the nitride ceramic are closely adhered to each other.

A preferred example of the oxide is at least one selected from the group consisting of lead oxide, zinc oxide, silica, boron oxide ($B_2O_3$), alumina, yttria, and titania.

These oxides make it possible to improve adhesiveness between the metal particles and the nitride ceramic without increasing the ohmic value of the heating elements.

When the total amount of the metal oxides is set to 100 parts by weight, the weight ratio of lead oxide, zinc oxide, silica, boron oxide ($B_2O_3$), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. The ratio is preferably adjusted within the scope that the total thereof is not over 100 parts by weight.

By adjusting the amounts of these oxides within these ranges, the adhesiveness to the aluminum nitride sintered body can be particularly improved.

The addition amount of the metal oxides to the metal particles is preferably 0.1 % by weight or more and less than 10 % by weight. The area resistivity when the conductor containing paste having such a composition is used to form the heating elements is preferably from 1 to 45 mΩ/□.

If the area resistivity is over 45 mΩ/□, the carolific value for an applied voltage becomes too large so that, in the aluminum nitride substrate wherein heating elements 12 are set on its surface, their carolific value is not easily controlled. If the addition amount of the metal oxides is 10 % or more by. weight, the area resistivity exceeds 50 mΩ/□ so that the carolific value becomes too large. Thus, temperature-control is not easily performed so that the uniformity in temperature distribution becomes poor.

In the case that the heating elements are formed on the surface of the aluminum nitride substrate, a metal covering layer is preferably formed on the surface of the heating elements. The metal covering layer prevents a change in the ohmic value based on oxidization of the inner metal sintered product. The thickness of. the formed metal covering layer is preferably from 0.1 to 10 μm.

The metal used when the metal covering layer is formed is not particularly limited if the metal is a metal which is hardly oxidized. Specific examples thereof include gold, silver, palladium, platinum, and nickel. These may be used alone or in combination of two or more. Among these metals, nickel is preferred.

In the case that the heating elements are formed inside the heater plate, no coating is necessary since the surface of the heating elements is not oxidized.

In the case that the metal layer is formed on the surface of the aluminum nitride sintered body or a coating layer is further formed on the metal layer, physical vapor depositing means such as sputtering or chemical vapor depositing means such as plating may be adopted other than the application of the conductor containing paste.

The following will describe the ceramic substrate for a semiconductor producing/examining device of the present invention.

The ceramic substrate for a semiconductor producing/examining device of the present invention (which may be referred merely to the ceramic substrate for a semiconductor device hereinafter) is a ceramic substrate using a ceramic made of an aluminum nitride sintered body having the above-mentioned property, and so on, wherein the ceramic substrate comprising carbon whose peaks appear near 1580cm$^{-1}$ and near 1355 cm$^{-1}$ in laser Raman spectral analysis is equipped with a conductor.

In the ceramic substrate for a semiconductor device of the present invention, the peak intensity ratio I(1580)/I(1355) which is the ratio of the peak near 1580 cm$^{-1}$ to the peak near 1355 cm$^{-1}$ in laser Raman spectral analysis, may be 3.0 or less. If the peak intensity ratio I(1580)/I(1355) is 3.0 or less, the percentage of contained crystalline carbon is small. Therefore, in a high temperature range of 200 °C or higher, a high volume resistivity can be sufficiently kept.

In the ceramic substrate for a semiconductor device of the present invention, the peak intensity ratio I(1580)/I(1355) , which is the ratio of the peak near 1580 cm$^{-1}$ to the peak near 1355 cm$^{-1}$ in laser Raman spectral analysis, may be over 3.0. If the peak intensity ratio I(1580)/I(1355) is over 3.0, the percentage of contained crystalline carbon is large. Therefore, a high fracture toughness (2.5 MPam$^{1/2}$ or more) can be sufficiently kept.

In the case that a drop in the thermal conductivity at high temperature has to be suppressed, the peak intensity ratio I(1580)/I(1355) is preferably 1.0 or more. If the peak intensity ratio I(1580)/I(1355) is below 1.0, the degree of the amorphousness is large and the thermal conductivity at high temperature drops.

If the peak intensity ratio I(1580)/I(1355) is over 3.0, a high thermal conductivity of 60 W/m • k or more can be kept in the high temperature region.

Conversely, in the case that the volume resistivity at high temperature has to be lowered, I(1580)/I(1355) is desirably set to less than 1.0.

In short, the peak intensity ratio is adjusted according to the use thereof.

In the ceramic substrate for a semiconductor device of the present invention, it is desired that peaks appear near 1580 cm$^{-1}$ and near 1355 cm$^{-1}$ in laser Raman spectral analysis, and the half-width (full width at half maximum) of the peak near 1355 cm$^{-1}$ is 20 cm$^{-1}$ or more. If the half-width (full width at half maximum) of the peak near 1355 cm$^{-1}$ is below 20 cm$^{-1}$, the crystallinity is high so that in some cases a drop in the volume resistivity in a high temperature range of 200 °C or higher cannot be sufficiently suppressed. The half-width (full width at half maximum) of the peak near 1355 cm$^{-1}$ is desirably 40 cm$^{-1}$ or more and is optimally 45 cm$^{-1}$ or more.

In the ceramic substrate for a semiconductor device of the present invention, it is desired that the content of carbon whose peaks appear near 1580 $cm^{-1}$ and near 1355 $cm^{-1}$ in laser Raman spectral analysis is desirably from 200 to 5000 ppm. If the content is below 200 ppm, the sintered body is not black and has a brightness of more than N4. On the other hand, the added amount is over 5000 ppm, the sinterability of the ceramic substrate drops.

The specific method for obtaining a ceramic substrate comprising carbon whose peaks are detected near 1580 $cm^{-1}$ and near 1355 $cm^{-1}$ in laser Raman spectral analysis is not particularly limited, but substantially the same methods of the above-mentioned methods may be used. That is, (1) a method of mixing an acrylic resin having an acid value of 5 to 17 KOHmg/g with a ceramic raw material; forming the resultant; decomposing, carbonizing and thermally-decomposing the formed body at a temperature of 350 °C or higher in an inert gas atmosphere (nitrogen gas or argon gas) ; and subsequently heating and pressing the body to produce a ceramic substrate; and (2) a method of mixing an acrylic resin having an acid value of 0.3 to 1.0 KOHmg/g with a ceramic raw material; forming the resultant; decomposing, carbonizing and thermally-decomposing the formed body at a temperature of 350 °C or higher in an inert gas atmosphere (nitrogen gas or argon gas) ; and subsequently heating and pressing the body to produce a ceramic substrate

The ceramic material constituting the ceramic substrate for a semiconductor device of the present invention is not especially limited. Examples thereof include nitride ceramics, carbide ceramics, and oxide ceramics.

Examples of the nitride ceramics include metal nitride ceramics such as aluminum nitride, silicon nitride and boron nitride.

Examples of the carbide ceramics include metal carbide ceramics such as silicon carbide, zirconium carbide, titanium carbide, tantalum carbide, and tungsten carbide.

Examples of the oxide ceramics include metal oxide ceramics such as alumina, zirconia, cordierite and mullite.

These ceramics may be used alone or in combination of two or more thereof.

Among these ceramics, nitride ceramics and carbide ceramics are more preferred than oxide ceramics. This is because they have a high thermal conductivity.

Aluminum nitride is most preferred among nitride ceramics since its thermal conductivity is highest, that is, 180 W/m • K.

In the present invention, it is desired that the sintered body constituting the ceramic substrate for a semiconductor device comprises a sintering aid. The sintering aid that can be used may be an alkali metal oxide, an alkali earth metal oxide or a rare element oxide, and is particularly preferably CaO, $Y_2O_3$, $Na_2O$, $Li_2O$ or $Rb_2O$ among these sintering aids. The content of these sintering aids is desirably from 0.1 to 10 % by weight. Also, alumina may be added.

In the ceramic substrate for a semiconductor device of the present invention, its brightness is desirably N4 or less as the value based on the rule of JIS Z 8721. This is because the sintered body having such a brightness is superior in radiant heat amount and covering-up ability. The surface temperature of such a ceramic substrate for a semiconductor device can be accurately measured with a thermoviewer.

The ceramic substrate for a semiconductor device of the present invention has a disc-shape. The diameter thereof is desirably 200 mm or more, and is optimally 250 mm or more.

In the disc-shape ceramic substrate for a semiconductor device, the uniformity of the temperature is required since the temperature becomes not uniform more easily as the diameter of the substrate is larger.

The thickness of the ceramic substrate for a semiconductor device of the present invention is preferably 50 mm or less, more preferably 20 mm or less, and most preferably 1 to 5 mm.

If the thickness is too thin, warps are caused at high temperature. If the thickness is too thick, the heat capacity becomes too large so that temperature rising/falling property becomes poor.

The porosity of the ceramic substrate for a semiconductor device of the present invention is desirably 0, or not more than 5 %. This is because it is possible to suppress a drop in the thermal conductivity at high temperature and generation of warps. The porosity is measured by Archimedes' method.

The ceramic substrate for a semiconductor device of the present invention is a ceramic substrate used in a device for producing or examining a semiconductor. Specific examples thereof include an electrostatic chuck, a wafer prober, a hot plate and susceptor.

In the ceramic substrate for a semiconductor device of the present invention, a conductor comprising a conductive metal or a conductive ceramic is equipped. When this conductor is an electrostatic chuck, the above-mentioned ceramic substrate functions as an electrostatic chuck.

Preferred examples of the above-mentioned metal include a noble metal (gold, silver, platinum and palladium), lead, tungsten, molybdenum, and nickel. Examples of the conductive ceramic include carbides of tungsten and molybdenum. These may be used alone or in combination of two or more.

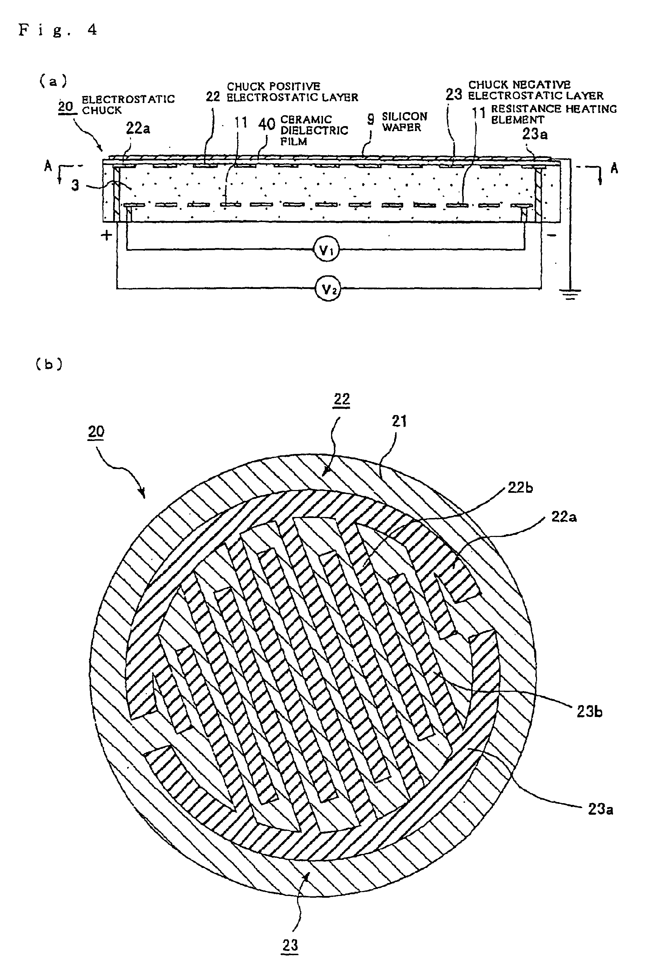

Referring to FIG. 4, the following will describe the ceramic substrate for a semiconductor device of the present invention, which functions as an electrostatic chuck.

In this electrostatic chuck 20, chuck positive and negative electrode layers 22 and 23 are buried in a ceramic substrate 3. A ceramic dielectric film 40 is formed on the electrodes. Resistance heating elements 11 are disposed inside the ceramic substrate 3 so that a silicon wafer 9 can be heated. If necessary, RF electrodes may be buried in the ceramic substrate 3.

As shown in (b), the electrostatic chuck 20 is usually made in a circular form as is viewed from the above. The chuck positive electrostatic layer 22 composed of a semicircular part 22a and a comb-teeth-shaped part 22b and the chuck negative electrostatic layer 23 composed of a semicircular part 23a and a comb-teeth-shaped part 23b, which are shown in FIG. 4, are arranged oppositely to each other inside the ceramic substrate 21 so that the comb-teeth-shaped parts 22b and 23b cross each other.

When this electrostatic chuck is used, the positive side and the negative side of a DC power source are connected to the chuck positive electrostatic layer 22 and chuck negative electrostatic layer 23, respectively. In this way, the semiconductor wafer put on this electrostatic chuck is electrostatically adsorbed.

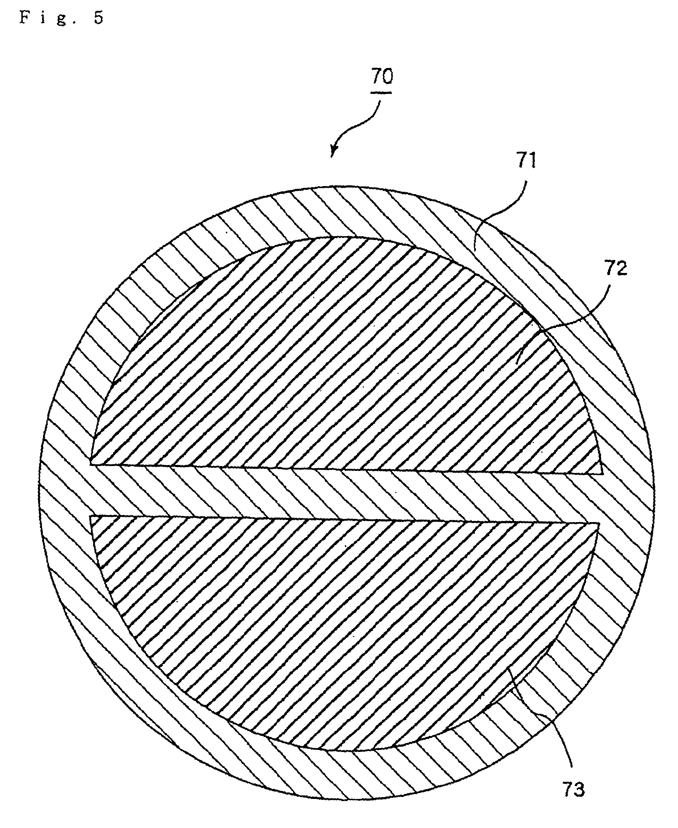

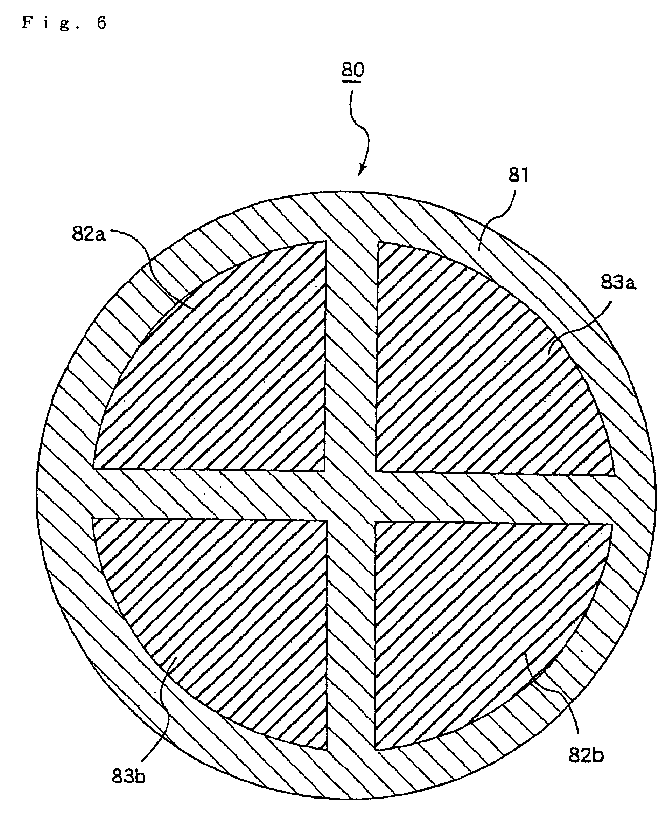

FIGs. 5 and 6 are horizontal sectional views, each of which schematically shows electrostatic electrodes in a different electrostatic chuck. In an electrostatic chuck 70 shown in FIG. 5, a chuck positive electrostatic layer 72 and a chuck negative electrostatic layer 73 in a semicircular form are formed inside a ceramic substrate 71. In an electrostatic chuck 80 shown in FIG. 6, chuck positive electrostatic layers 82a and 82b and chuck negative electrostatic layers 83a and 83b, each of which has a shape obtained by dividing a circle into 4 parts, are formed inside a ceramic substrate 81. The two chuck positive electrostatic layers 82a and 82b and the two chuck negative electrostatic layers 83a and 83b are formed to cross.

In the case that an electrode having such a form in which an electrode having a circular shape or the like shape is divided is made, the number of divided pieces is not particularly limited and may be 5 or more. Its shape is not limited to a fan-shape.

In the case that the conductor embedded in the ceramic substrate for a semiconductor device of the present invention is a resistance heating element, the ceramic substrate functions as a hot plate.

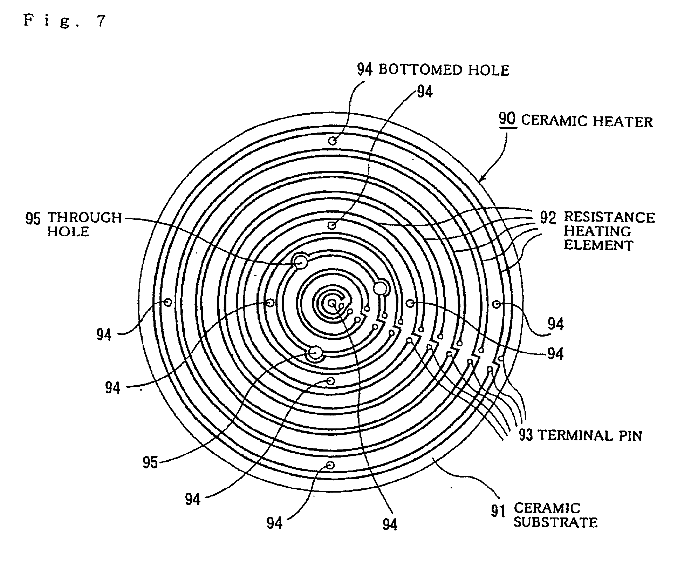

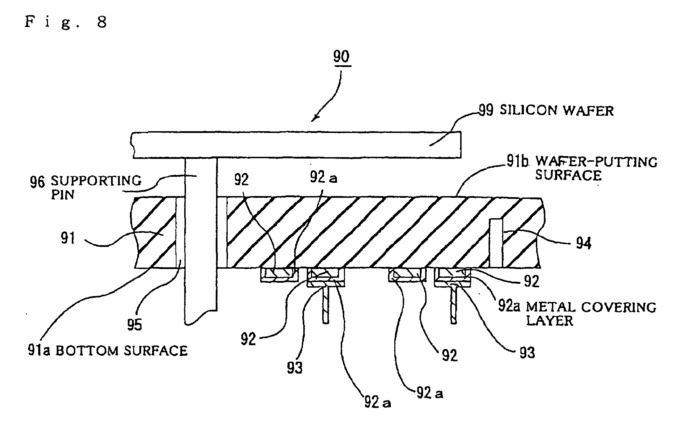

FIG. 7 is a bottom surface view that schematically shows an example of a hot plate (which may be referred to as a ceramic heater hereinafter) that is one embodiment of the ceramic substrate for a semiconductor device of the present invention. FIG. 8 is a partially enlarged section showing a part of the ceramic heater schematically.

A ceramic substrate 91 is made in a disk form. Resistance heating elements 92 are made in the pattern of concentric circles on the bottom surface of the ceramic substrate 91, in order to heat the semiconductor wafer-putting surface of the ceramic substrate 91 in the way that the temperature of the whole thereof is uniform. A metal covering layer 92a is formed on the surface thereof.

About the resistance heating elements 92, two concentric circles near to each other, as a pair, are connected to produce one line, and external terminal pins 93, which will be inputting/outputting terminal pins, are connected to both ends thereof. Through holes 95, through which supporting pins 96 are inserted, are made in an area near the center. Besides, bottomed holes 94, in which temperature-measuring elements are inserted, are made.

As shown in FIG. 8, the support pins 96, on which a silicon wafer 99 can be put, can be moved up and down. In this way, the silicon wafer 99 can be delivered to a non-illustrated carrier machine or can be received from the carrier machine.

The resistance heating elements 92 shown in FIG. 7 are equipped on the bottom surface of the ceramic substrate 91, but the resistance heating elements 92 may be formed inside the ceramic substrate 91 at the medium position thereof or at the position biased toward the semiconductor wafer-putting surface from the medium position.

In the ceramic heater having such a structure, after a silicon wafer or the like is put thereon, various operations can be performed while the silicon wafer or the like is heated or cooled.

The above-mentioned ceramic substrate functions as a wafer prober in the case that; conductors are equipped on the surface of the ceramic substrate for a semiconductor device of the present invention and inside the same ceramic substrate, the conductor inside being at least one of a guard electrode and/or a ground electrode.

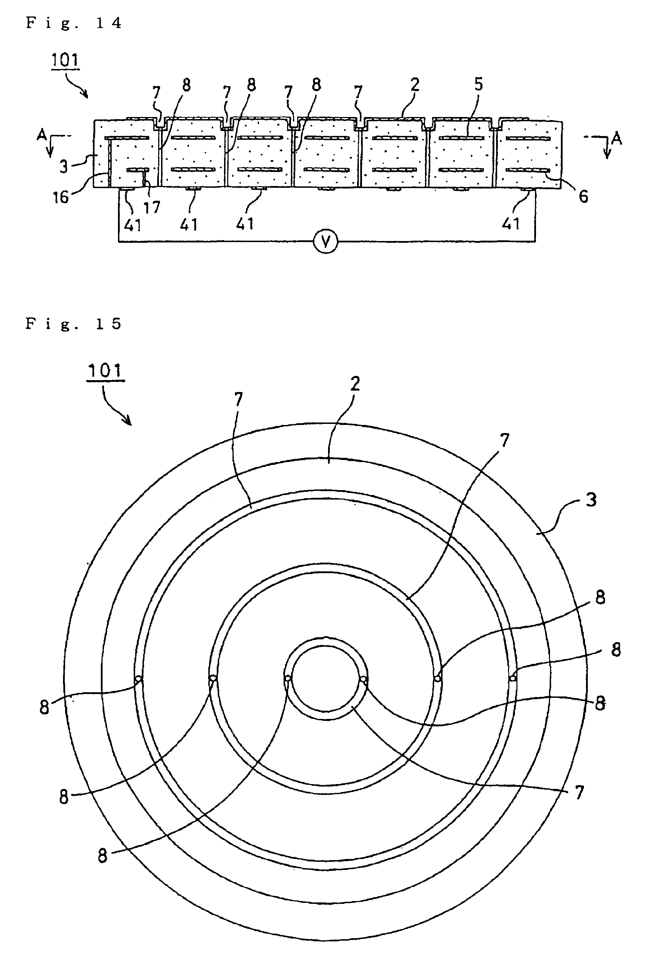

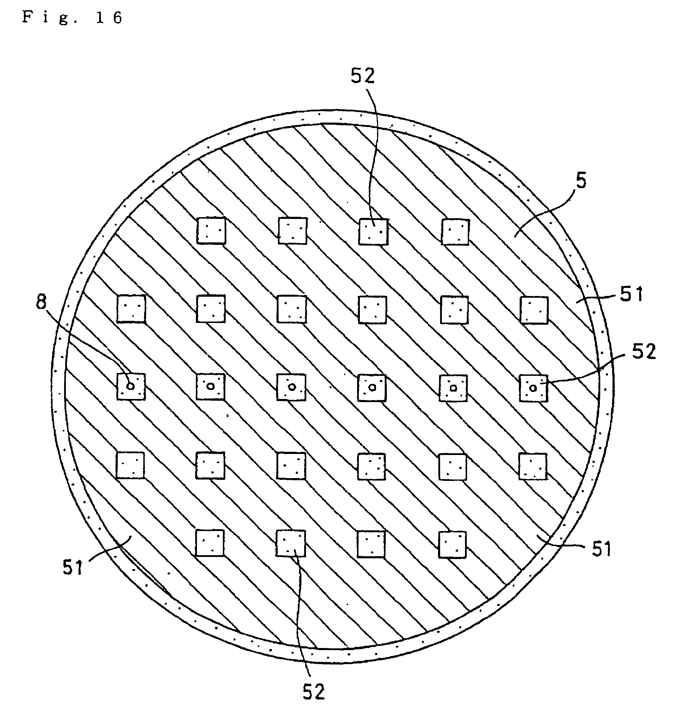

FIG. 14 is a sectional view that schematically shows one embodiment of the wafer prober of the present invention. FIG. 15 is a plain view thereof, and FIG. 16 is a sectional view taken along A-A line in the wafer prober shown in FIG. 14.

In this wafer prober 101, grooves 7 in the form of concentric circles are formed on the surface of a disc-shape ceramic substrate 3, which is in a circle form as viewed from the above. Moreover, suction holes 8 for sucking a silicon wafer are formed in a part of the grooves 7. A chuck top conductor layer 2 for connecting electrodes of the silicon wafer is formed, in a circular form, in the greater part of the ceramic substrate.3 including the grooves 7.

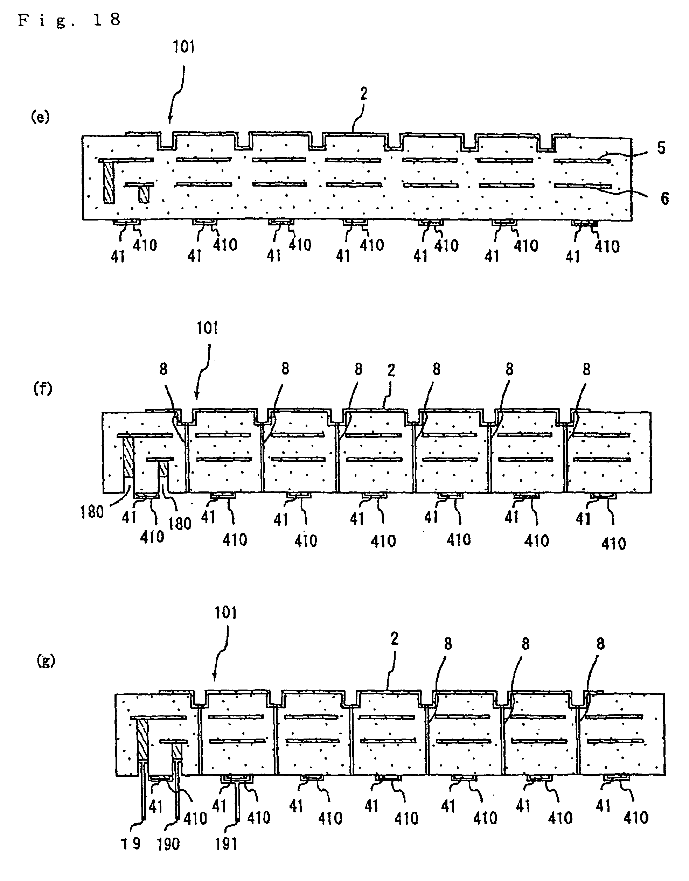

On the other hand, heating elements 41 as shown in FIG. 7, in the form of concentric circles as viewed from the above, are disposed on the bottom surface of the ceramic substrate 3 to control the temperature of the silicon wafer. External terminal pins 191 (see FIG. 18) are connected and fixed to both ends of the heating element 41. Inside the ceramic substrate 3, guard electrodes 5 and ground electrodes 6 (see FIG. 18), in the form of a lattice as shown in FIG. 16, are disposed to remove stray capacitors or noises.

After a silicon wafer, on which integrated circuits are formed, is put on the wafer prober having such a structure, a probe card having a tester pin is pressed against this silicon wafer. Then, a voltage is applied thereto while the silicone wafer is heated or cooled, so that a continuity test can be performed.

The following will describe one example of the process for producing a ceramic substrate for a semiconductor device of the present invention.

(1) An acrylic resin having an acid value of 5 to 17 KOHmg/g is mixed with ceramic powder, which will be a matrix component. About the size of the powder to be mixed, its average diameter is preferably from about 0.1 to about 5 μm. This is because as the powder is finer, the sinterability thereof is more improved. Carbon is added, considering the amount of the carbon lost when the mixture is fired. In the case that an aluminum nitride substrate or the like is produced, a sintering aid such as the above-mentioned yttrium oxide (yttria: $Y_2O_3$) may be added to the mixture.

(2) Next, the resultant powder mixture is put into a mold to prepare a formed body. This formed body is thermally decomposed at 350 °C or higher to carbonize the acrylic resin.

Instead of the processing of the steps (1) and (2), it is allowable to mix aluminum nitride powder, an acrylic resin having an acid value of 5 to 17 KOHmg/g, and a solvent to produce green sheets; laminate the green sheets; and pre-fire the lamination of the green sheets at 300 to 500 °C to prepare carbon used in the present invention. The solvent that can be used may be α-terpineol, glycol and the like.

(3) Next, the formed body resulting from the carbonization of the acrylic resin or the lamination of the green sheets (which has been pre-fired) is heated and pressured at 1500 to 1900 °C and 80 to 200 kg/cm$^2$ in an inert gas atmosphere of argon, nitrogen or the like so as to be sintered.

As the sintering temperature is closer to 1900 °C, the crystallinity of carbon is higher so that the peak intensity ratio I(1580)/I(1355) is larger. Therefore, the peak intensity ratio can be adjusted by the sintering temperature.

In the case that an acrylic resin having an acid value of 0.3 to 1.0 KOHmg/g is used instead of the acrylic resin having an acid value of 5 to 17 KOHmg/g, the ceramic substrate for a semiconductor device of the present invention can be produced in the same way.

The ceramic substrate for a semiconductor device of the present invention can be produced by firing a formed body made basically of a ceramic powder mixture or a green sheet lamination. A ceramic substrate having therein heating elements can be produced; by embedding metal plates (foils), metal wires or the like, which will be resistance heating elements, in the powder mixture when the powder mixture is put into the mold; or by forming a conductor containing paste layer, which will be heating elements, on one green sheet among the laminated green sheets.

When a sintered body is produced, heating elements can be formed on the bottom surface by forming a conductor containing paste on its surface (bottom surface) and firing the resultant.

Furthermore, by embedding metal plates (foils) or the like in the formed body or forming a conductor containing paste layer on the green sheet to have shapes of heating elements or electrodes such as electrostatic chucks at the time of producing the ceramic substrate, a hot plate, an electrostatic chuck, a wafer prober, a susceptor or the like can be produced.

The conductor containing paste for producing the various electrodes or heating elements is not particularly limited, but the same conductor containing paste as described in the process for producing the aluminum nitride sintered body can be used.

In the case that the heating elements are formed on the surface of the ceramic substrate, a metal covering layer is preferably formed on the surfaces of the heating elements. The metal covering layer prevents a change in the ohmic value based on oxidization of the inner metal sintered product. The thickness of the formed metal covering layer is preferably from 0.1 to 10 μm.

The metal used when the metal covering layer is formed is not particularly limited if the metal is a metal which is hardly oxidized. Specific examples thereof include gold, silver, palladium, platinum, and nickel. These may be used alone or in combination of two or more. Among these metals, nickel is preferred.

Best Modes for Carrying Out the Invention

(Example 1)

(1) The following were mixed and then the mixture was put into a mold to prepare a formed body: 100 parts by weight of aluminum nitride powder (made by Tokuyama Corp., average particle diameter: 1.1 μm), 4 parts by weight of yttrium oxide ($Y_2O_3$: yttria, average particle diameter: 0.4 μm), and 8 parts by weight of an acrylic resin binder (made by Kyoeisyha Chemical Co., Ltd., trade name: KC-600, acid value: 10 KOHmg/g).

(2) The formed body was heated at 350 °C in the atmosphere of nitrogen for 4 hours to decompose the acrylic resin binder thermally.

(3) The formed body was hot-pressed under the conditions of 1890 °C and a pressure of 150 kg/cm$^2$ for 3 hours

to obtain an aluminum nitride sintered body.

The amount of carbon in the sintered body was measured by pulverizing the sintered body, heating the resultant at 500 to 800 °C, and then collecting generated $CO_x$ gas. The result of the measurement by this method demonstrated that the carbon content in the aluminum nitride sintered body was 800 ppm. The brightness N thereof was 3.5.

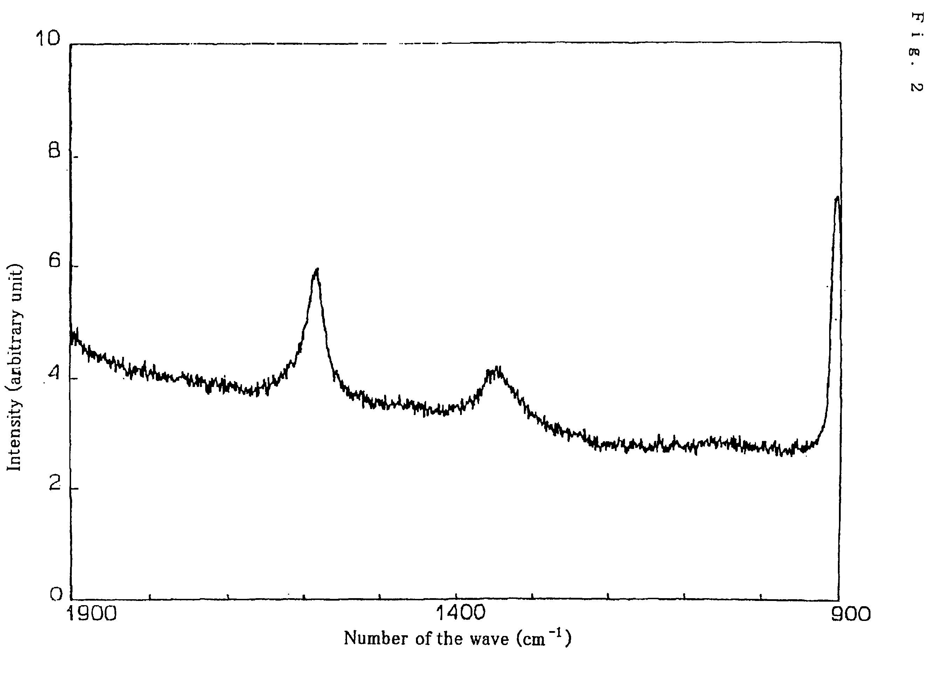

FIG. 2 is a laser Raman spectrum showing the result of laser Raman spectral analysis of carbon in the sintered body obtained in the present Example 1. Conditions for the measurement, using a micro Raman (JOBIN Y VON RAMANOR U-100), were as follows: laser power: 200 mW, laser beam diameter: 20 μm, excited wavelength: 514.5 nm, slit width: 1000 μm, gate time: 1, repeat time: 4, and temperature: 25.0 °C.

As is evident from the laser Raman spectrum shown in FIG. 2, peaks were clearly observed near 1580 $cm^{-1}$ and near 1355 $cm^{-1}$, and the present carbon was carbon with lowered crystallinity. The peak intensity ratio I(1580)/I (1355) was 2.3 and the half-width of the peak at 1355 $cm^{-1}$ was 45 $cm^{-1}$.

(Example 2)

(1) The following were mixed and then the mixture was put into a mold to prepare a formed body: 100 parts by weight of aluminum nitride powder (made by Tokuyama Corp., average particle diameter: 1.1 μm), and 8 parts by weight of an acrylic resin binder (made by Kyoeisyha Chemical Co. , Ltd. , trade name: KC-600, acid value: 17 KOHmg/g).
(2) The formed body was heated at 600 °C in the atmosphere of nitrogen for 1 hour to decompose the acrylic resin binder thermally.
(3) The formed body was hot-pressed under conditions of 1890 °C and a pressure of 150 kg/cm$^2$ for 3 hours to obtain an aluminum nitride sintered body.

The carbon content in the resultant aluminum nitride sintered body was 805 ppm. The brightness N thereof was 3.5.

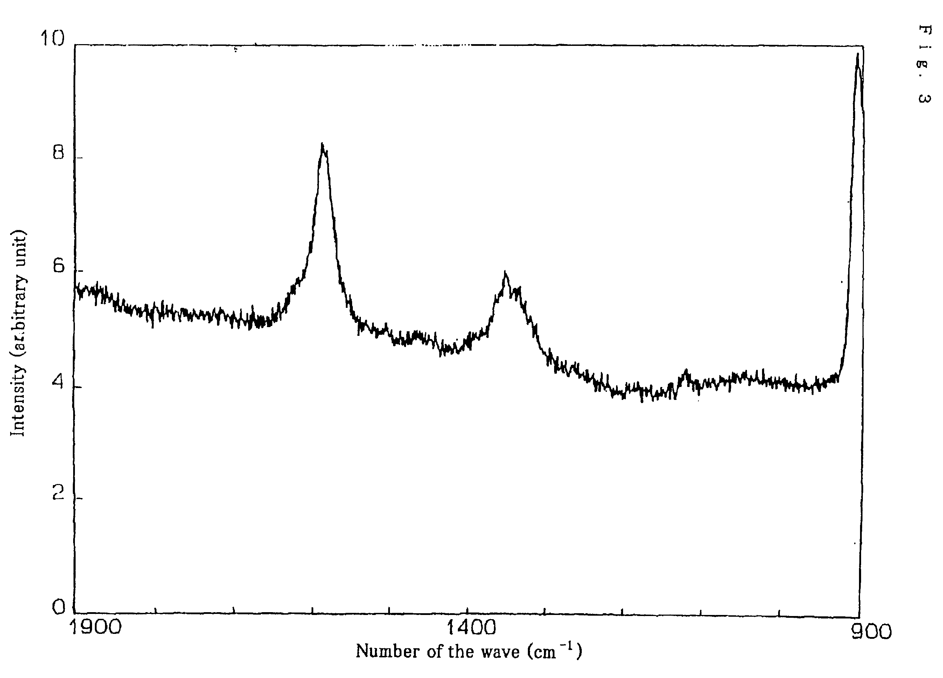

FIG. 3 is a laser Raman spectrum showing the result of laser Raman spectral analysis of carbon in the sintered body obtained in the present Example 2. Conditions for the measurement were the same as in Example 1.

As is evident from the laser Raman spectrum shown in FIG. 3, about the aluminum nitride sintered body obtained in Example 2, peaks were clearly observed near 1580 $cm^{-1}$ and near 1355 $cm^{-1}$, and its crystal system was kept but a part of crystal was broken to become amorphous. The peak intensity ratio I(1580)/I(1355) was 2.1 and the half-width of the peak at 1355 $cm^{-1}$ was 45 $cm^{-1}$.

(Example 3)

(1) The following were mixed and then the mixture was put into a mold to prepare a formed body: 100 parts by weight of aluminum nitride powder (made by Tokuyama Corp., average particle diameter: 1.1 μm), 4 parts by weight of yttrium oxide ($Y_2O_3$: yttria, average particle diameter: 0.4 μm), and 8 parts by weight of an acrylic resin binder (made by Kyoeisyha Chemical Co., Ltd., trade name: KC-600, acid value: 10 KOHmg/g).
(2) The formed body was heated at 350 °C in the atmosphere of nitrogen for 4 hours to decompose the acrylic resin binder thermally.
(3) The formed body was hot-pressed under conditions of 1750 °C and a pressure of 150 kg/cm$^2$ for 3 hours to obtain an aluminum nitride sintered body.

The carbon content in the aluminum nitride sintered body was 800 ppm. The brightness N thereof was 3.5.

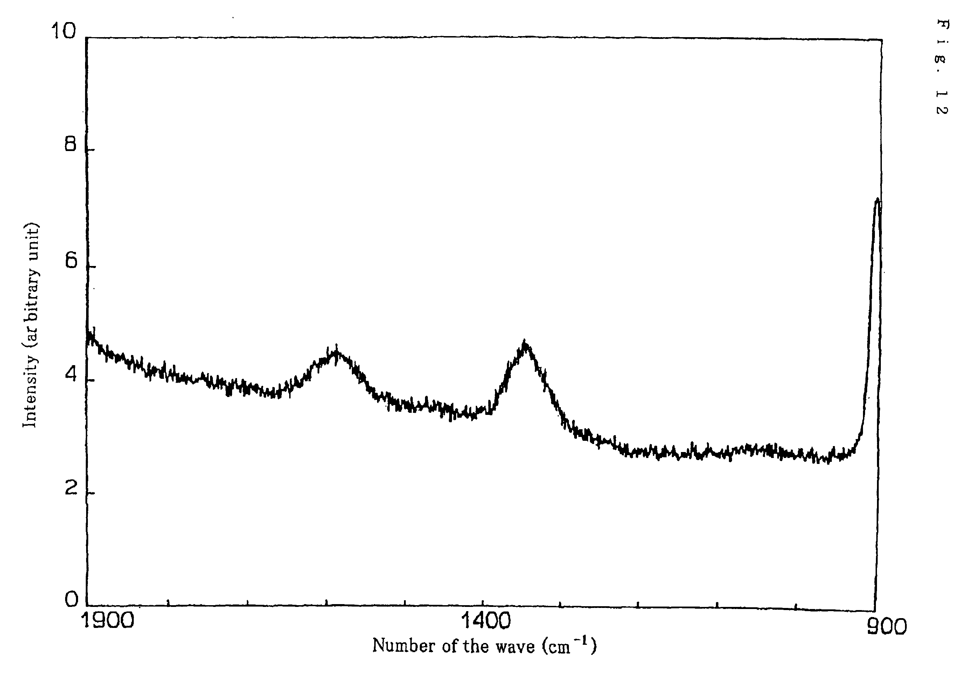

According to laser Raman spectral analysis of carbon in the aluminum nitride sintered body obtained in the present Example 3, the peak intensity ratio I(1580)/I(1355) was 0.7 and the half-width of the peak at 1355 $cm^{-1}$ was 55 $cm^{-1}$ (see FIG. 12) .

It is presumed that an amorphous component was large since the sintering temperature was low so that crystallization did not advance.

(Comparative Example 1)

(1) The following were mixed and then the mixture was put into a mold to prepare a formed body: 100 parts by weight of aluminum nitride powder (made by Tokuyama Corp., average particle diameter: 1.1 $\mu$m), 4 parts by weight of yttrium oxide ($Y_2O_3$: yttria, average particle diameter: 0.4 $\mu$m), and 0.10 part by weight of crystalline graphite (made by Toyo Tanso Inc, GR-1200).
(2) The formed body was hot-pressed under conditions of 1900 °C and a pressure of 150 kg/cm$^2$ for 3 hours to obtain an aluminum nitride sintered body.

The carbon content in the aluminum nitride sintered body was 800 ppm. The brightness N thereof was 3.5.

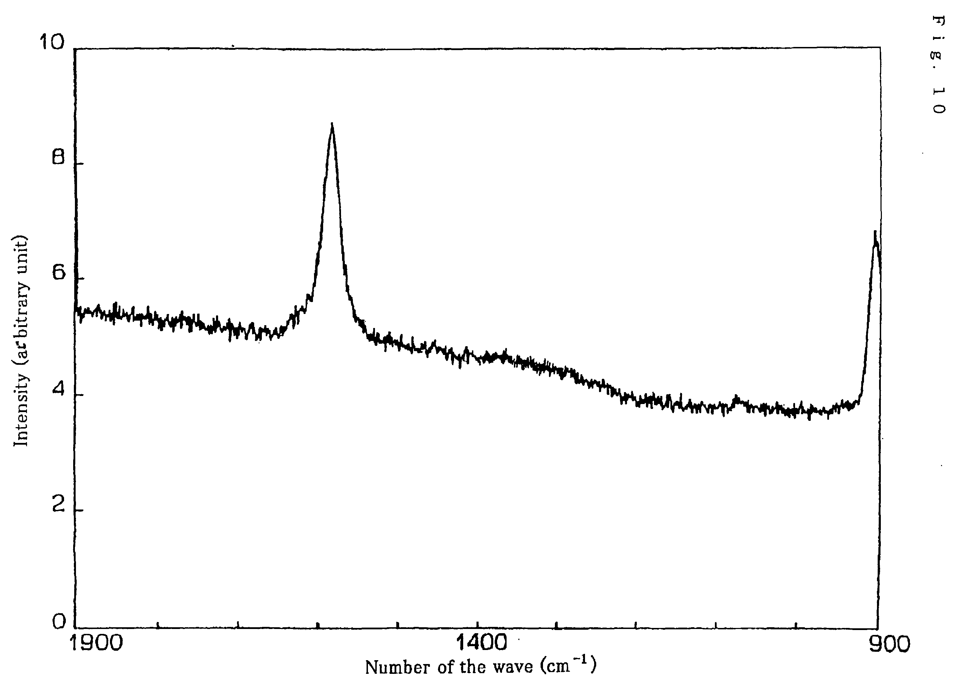

FIG. 10 is a laser Raman spectrum showing the result of laser Raman spectral analysis of the sintered body obtained in the present Comparative Example 1. Conditions for the measurement were the same as in Example 1. According to the laser Raman spectral analysis of the aluminum nitride sintered body, a peak was observed only at 1580 cm$^{-1}$.

(Comparative Example 2)

(1) The following were mixed and then the mixture was put into a mold to prepare a formed body: 100 parts by weight of aluminum nitride powder (made by Tokuyama Corp., average particle diameter: 1.1 $\mu$m), and 4 parts by weight of yttrium oxide ($Y_2O_3$: yttria, average particle diameter: 0.4 $\mu$m).
(2) The formed body was hot-pressed under conditions of 1900 °C and a pressure of 150 kg/cm$^2$ for 3 hours to obtain an aluminum nitride sintered body.

The carbon content in the resultant aluminum nitride sintered body was 50 ppm or less. It was presumed that the carbon originated from the raw materials. The brightness N thereof was 7.0.
FIG. 1 shows transition in the volume resistivities from room temperature to 500 °C of Examples 1 to 3 and Comparative Examples 1 and 2.
As shown in FIG. 1, on the sintered body comprising only crystalline carbon, which is indicated as Comparative Example 1, its volume resistivity at 500 °C was about 1/10 of those in the Examples.
In the above-mentioned measurement, the volume resistivity and the thermal conductivity were measured as follows.

(1) Volume resistivity: A sintered body was cut into a piece having a diameter of 10 mm and a thickness of 3 mm. Three terminals (a main electrode, an opposite electrode, and a guard electrode) were formed, and then a DC voltage was applied thereto to charge the sintered body for one minute. Thereafter, the electric current (I) flowing through a digital electrometer was read to obtain the resistance (R) of the sample. The volume resistivity ($\rho$) was calculated in accordance with the following calculating equation (1) from the resistance (R) and the size of the sample:

$$\rho = \varepsilon/t \times R = S/t \times V/1 \tag{1}$$

wherein t is the thickness (mm) of the sample and S is given by the following calculating equations (2) and (3).

$$D_0 = 2r_0 = (D_1 + D_2)/2 = 1.525 \text{ cm} \tag{2}$$

$$S = \pi D_0^2/4 = 1.83 \text{ cm}^2 \tag{3}$$

In the calculating equations (2) and (3), $r_1$ is the radius of the main electrode, $r_2$ is the inner size (radius) of the guard electrode, $r_3$ is the outer size (radius) of the guard electrode, $D_1$ is the diameter of the main electrode, $D_2$ is the inner size (diameter) of the guard electrode, $D_3$ is the outer size (diameter) of the guard electrode. In the present

Examples, $2r_1 = D_1 = 1.45$ cm, $2r_2 = D_2 = 1.60$ cm, and $2r_3 = D_3 = 2.00$ cm/

(2) Thermal conductivity:

a. Used machine

Rigaku laser flash method thermal constant measuring machine LF/TCM-FA8510B

b. Test conditions

Temperature: ambient temperature, 200 °C, 400 °C, 500 °C, and 700 °C
Atmosphere: vacuum

c. Measuring method

Temperature in specific heat measurement was detected with a thermocouple (Platinel) bonded to the back surface of the sample with silver paste.
Specific heat at ambient temperature was measured in the state that a light receiving plate (glassy carbon) was bonded to the upper surface of the sample through silicone grease. The specific heat (Cp) of the sample was obtained from the following calculating equation (4):

$$Cp = (\Delta Q/\Delta T - Cp_{G.C} \times W_{G.C} - Cp_{S.G} \times W_{S.G}) \, (1/W) \tag{4}$$

In the calculating equation (4), $\Delta Q$ is an input energy, $\Delta T$ is the saturated value of rising temperature of the sample, $Cp_{G.C}$ is the specific heat of the glassy carbon, $W_{G.C}$ is the weight of the glassy carbon, $Cp_{S.G}$ is the specific heat of the silicone grease, $W_{S.G}$ is the weight of the silicone grease, and W is the weight of the sample.

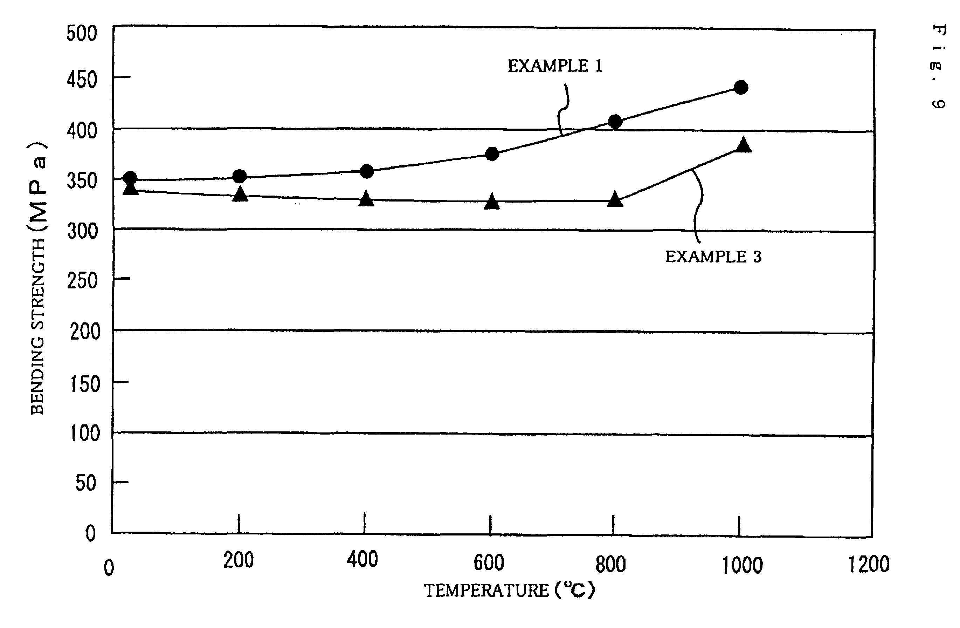

FIG. 9 shows results of measurement of strength of the sintered bodies of Examples 1 and 3. As shown in FIG. 9, in the aluminum nitride sintered body wherein carbon was more made to be amorphous, its strength did not rise very much. The strength was measured in the atmosphere at 25 to 1000 °C, using an Instron universal testing machine (4507 type, load cell: 500 kgf), under the following conditions: cross head speed: 0.5 mm/minute, span length L: 30 mm, thickness of the test piece: 3.06 mm, and width of the test piece: 4.03 mm. Using the following calculating equation (5), three-point bending strength $\sigma$(kgf/mm$^2$) was calculated:

$$\sigma = 3PL/2wt^2 \tag{5}$$

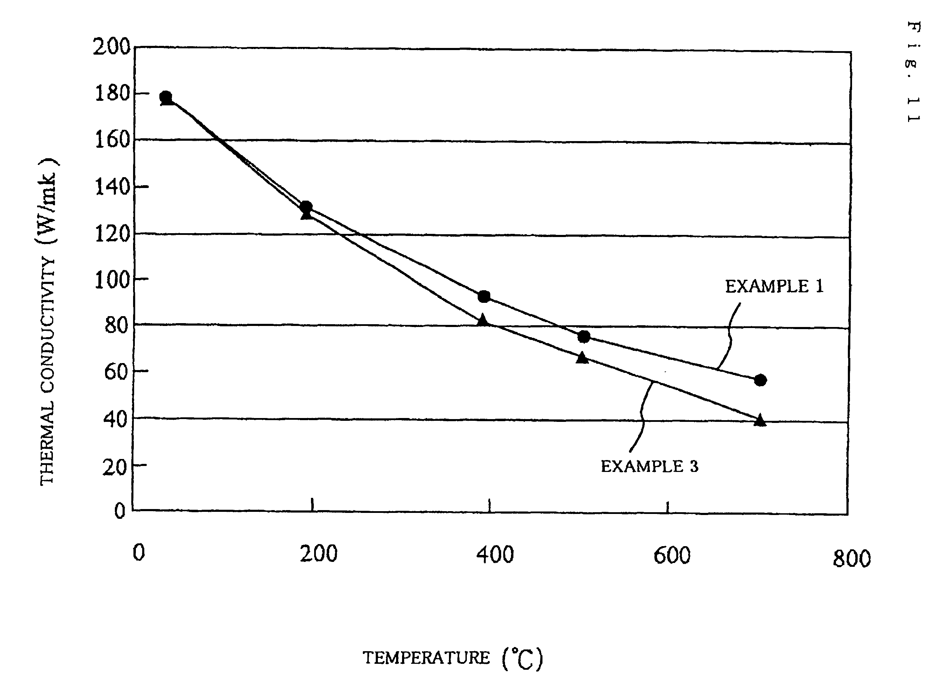

In the calculating equation (5), P is the maximum load (kgf) when the test piece was broken, L is the distance (30 mm) between lower fulcra, t is the thickness (mm) of the test piece, and w is the width (mm) of the test piece.
The sintered bodies of Examples 1 to 3 and Comparative Examples 1 and 2 were heated up to 500 °C on a hot plate, their surface temperatures were measured with a thermoviewer (made by Japan Datum Inc., IR162012-0012) and a K type thermocouple according to JIS C 1602 (1980) to examine the difference of the measured temperatures of the two. It can be said that as a gap between the temperature measured with the thermocouple and that measured with the thermoviewer is larger, the temperature error with the thermoviewer is larger.
Results of the measurement are as follows: a temperature difference was 0.8 °C in Example 1; a temperature difference was 0.9 °C in Example 2; a temperature difference was 1.0 °C in Example 3; a temperature difference was 8 °C in Comparative Example 1; and a temperature difference was 0.8 °C in Comparative Example 2.
As shown in FIG. 11, in the aluminum nitride wherein carbon was more amorphous (Example 3), a drop in its thermal conductivity was large.

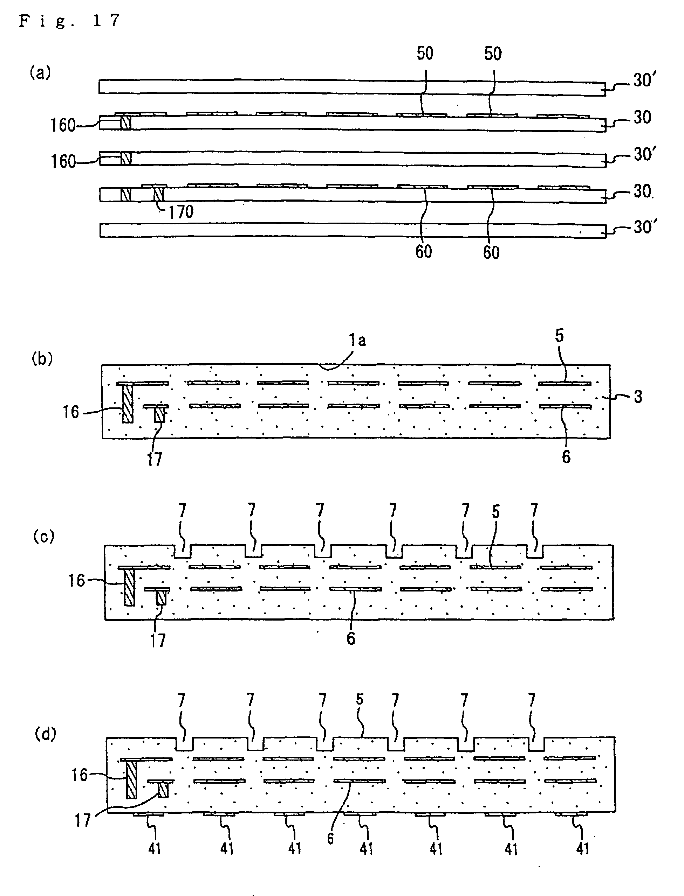

(Example 4) Application Example, wafer prober (.FIGs. 17 and 18)

(1) A composition obtained by mixing the following was used and formed by the doctor blade method to obtain a green sheet having a thickness of 0.47 mm: 100 parts by weight of aluminum nitride powder (made by Tokuyama Corp., average particle diameter: 1.1 µm), 4 parts by weight of yttria (average particle diameter: 0.4 µm), 8 parts by weight of an acrylic resin binder (Kyoeisyha Chemical Co., Ltd., trade name: KC-600, and acid value: 10 KOHmg/ g), and 53 % by weight of alcohol consisting of 1-butanol and ethanol.

(2) This green sheet 30 was dried at 80 °C for 5 hours, and punched to make through holes for plated through holes, for connecting heating elements and external terminals.

(3) A conductor containing paste A was prepared by mixing 100 parts by weight of tungsten carbide particles having an average particle diameter of 1 µm, 3.0 parts by weight of an acrylic binder, 3.5 parts by weight of α-terpineol solvent, and 0.3 part by weight of a dispersant. A conductor containing paste B was also prepared by mixing 100 parts by weight of tungsten particles having an average particle diameter of 3 µm, 1.9 parts by weight of an acrylic binder, 3.7 parts by weight of α-terpineol solvent, and 0.2 part by weight of a dispersant.

(4) The conductor containing paste A was printed on the surface of the green sheet 30 by screen printing, so as to form a printed layer 50 for guard electrodes and a printed layer 60 for ground electrodes in a lattice form.

The conductor containing paste B was filled into the through holes for plated through holes, for connecting external terminal pins, to form filled layers 160 and 170 for the plated through holes.

The green sheets 30 on which the conductor containing paste was printed and green sheets 30' on which no conductor containing paste was printed, the number of which was 50, were laminated and then the sheets were integrated with each other at 130 °C and a pressure of 80 kgf/cm$^2$ (see FIG. 17(a)).

(5) The lamination resulting from the integration was heated at 350 °C for 4 hours, and was then hot-pressed under conditions of 1890 °C and a pressure of 150 kg/cm$^2$, to obtain an aluminum nitride plate having a thickness of 3 mm. This plate was cut off into a disk of 230 mm in diameter to prepare an aluminum nitride substrate 3 (FIG. 17 (b)). About the size of plated through holes 16 and 17, their diameter was 0.2 mm and their depth was 0.2 mm. The thickness of guard electrodes 5 and ground electrodes 6 was 10 µm. The positions where the guard electrodes 5 were formed were 1 mm apart from the heating elements along the thickness direction of the sintered body. The positions where the ground electrodes 6 were formed were 1.2 mm apart from a chuck face 1a along the thickness direction of the sintered body. The carbon content was 810 ppm.

(6) The aluminum nitride substrate 3 obtained in the (5) was polished with a diamond grindstone. Subsequently a mask was put thereon, and concaves (not illustrated) for thermocouples and grooves 7 (width: 0.5 mm, and depth: 0.5 mm) for adsorbing a semiconductor wafer were formed in the surface by blast treatment with glass beads (FIG. 17(c)).

(7) Furthermore, a conductor containing paste was printed on the back surface, which is opposite to the chuck face 1a in which the grooves 7 were formed, so as to form a paste layer for heating elements. The used conductor containing paste was Solvest PS603D made of Tokuriki Kagaku Kenkyu-zyo, which is used to form plated through holes in printed circuit boards. Namely, this paste was a silver/lead paste, and contained metal oxides consisting of lead oxide, zinc oxide, silica, boron oxide and alumina (the weight ratio thereof was 5/55/10/25/5) in an amount of 7.5 % by weight of silver.

The used silver in the conductor containing paste was scaly particles having an average particle diameter of 4.5 µm.

(8) The aluminum nitride substrate (heater plate) 3, in which the conductor containing paste was printed on its back surface to form the heating elements 41, was heated and fired at 780 °C to sinter silver and lead in the conductor containing paste and further bake them on the aluminum nitride substrate 3. Thus, the heating elements 41 were formed (FIG. 17 (d)) . Next, this aluminum nitride substrate 3 was immersed in a bath for electroless nickel plating consisting of an aqueous solution containing 30 g/L of nickel sulfate, 30 g/L of boric acid, 30 g/L of ammonium chloride, and 60 g/L of a Rochelle salt, to precipitate a nickel layer 410 having a thickness of 1 µm and a boron content of 1 % or less by weight on the surface of the heating elements 41 which is made from the conductor containing paste. Thus, the thickness of the heating elements 41 was made larger. Thereafter, the aluminum nitride substrate was annealed at 120 °C for 3 hours.

The thus obtained elements 41 comprising the nickel layer 410 had a thickness of 5 µm, a width of 2.4 mm and a area resistivity of 7.7 mΩ/□

(9) By sputtering, a Ti layer, a Mo layer and a Ni layer were successively formed on the chuck face 1a in which the grooves 7 were formed. The used equipment for this sputtering was SV-4540 made by ULVAC Japan, Ltd. About conditions for the sputtering, air pressure was 0.6 Pa, temperature was 100 °C, electric power was 200 W, and process time was from 30 seconds to 1 minute. Sputtering time was adjusted according to the respective metals to be sputtered.

About the resultant films, an image from a fluorescent X-ray analyzer demonstrated that the thickness of Ti was 0.3 μm, that of Mo was 2 μm and that of Ni was 1 μm.

(10) The aluminum nitride substrate 3 obtained in the step (9) was immersed in a bath for electroless nickel plating consisting of an aqueous solution containing of 30 g/L of nickel sulfate, 30 g/L of boric acid, 30 g/L of ammonium chloride, and 60 g/L of a Rochelle salt to precipitate a nickel layer (thickness: 7 μm) having a boron content of 1 % or less by weight on the surface of the grooves 7 formed on the chuck face 1a. Thereafter, the aluminum nitride substrate was annealed at 120 °C for 3 hours.

The aluminum nitride substrate was immersed in an electroless gold plating solution containing 2 g/L of potassium gold cyanide, 75 g/L of ammonium chloride, 50 g/L of sodium citrate, and 10 g/L of sodium hypophosphite at 93 °C for 1 minute, to form a gold plating layer 1 μm in thickness on the nickel plating layer at the chuck face side of the aluminum nitride substrate 3. Thus, a chuck top conductor layer 2 was formed (see FIG. 18(e)).

(11) Air suction holes 8 piercing the back surface from the grooves 7 were formed by drilling, and then blind holes 180 for exposing plated through holes 16 and 17 were formed (see FIG. 18 (f)). Brazing gold made of Ni-Au (Au: 81.5 % by weight, Ni: 18.4 % by weight, and impurities: 0.1 % by weight) was heated and allowed to reflow at 970 °C to connect external terminal pins 19 and 190 made of koval to the blind holes 180 (see FIG. 18(g)). An external terminal pin 191 made of koval was also formed through a solder (tin 9/lead 1) on the heating elements 41.

(12) Thermocouples for controlling temperature were buried (which is not illustrated) in the concaves, so as to obtain a heater with a wafer prober.

(13) Thereafter, the heater with the wafer prober is usually fixed to a support stand made of stainless steel through a heat insulator made of ceramic fiber (made by Ibiden Co., Ltd. , trade name: Ibiwool). A jet nozzle for jetting cooling gas is made in the support stand to adjust the temperature of the wafer prober.

In the heater with the wafer prober, air is sucked from air suction holes 8 to adsorb and hold a semiconductor wafer put on the heater.

The thus produced heater with the wafer prober has a brightness N of 3.5 to give a larger radiant heat amount. The heater is also superior in the capability of covering up the guard electrodes 5 and the ground electrodes 6. A drop in the volume resistivity at high temperature can be suppressed, and no short circuit is caused in operation. A leakage current can also be reduced and prevented.

(Example 5) Application Example, ceramic heater having therein heating elements and electrostatic electrodes for an electrostatic chuck (FIG. 4)

(1) The following paste was used to conduct formation by the blade method to obtain a green sheet of 0.47 mm in thickness: a paste obtained by mixing 100 parts by weight of aluminum nitride powder (made by Tokuyama Corp., average particle diameter: 1.1 μm), 4 parts by weight of yttria (average particle diameter: 0.4 μm), 11.5 parts by weight of an acrylic binder, 0.5 part by weight of a dispersant, 8 parts by weight of an acrylic resin binder (made by Kyoeisyha Chemical Co., Ltd., trade name: KC-600, and acid value: 17 KOHmg/g) and 53 parts by weight of mixed alcohols of 1-butanol and ethanol.

(2) Next, this green sheet was dried at 80 °C for 5 hours, and subsequently the following holes were made by punching: holes which would be through holes through which semiconductor wafer supporting pins 1.8 mm, 3.0 mm and 5.0 mm in diameter were inserted; and holes which would be plated through holes for connecting external terminals.

(3) The following were mixed to prepare a conductor containing paste A: 100 parts by weight of tungsten carbide particles having an average particle diameter of 1 μm, 3.0 parts by weight of an acrylic binder, 3.5 parts by weight of α-terpineol solvent, and 0.3 part by weight of a dispersant.

The following were mixed to prepare a conductor containing paste B: 100 parts by weight of tungsten particles having an average particle diameter of 3 μm, 1.9 parts by weight of an acrylic binder, 3.7 parts by weight of α-terpineol solvent, and 0.2 part by weight of a dispersant.

This conductor containing paste A was printed on the green sheet by screen printing, to form a conductor containing paste layer. The pattern of the printing was made into a concentric pattern. Furthermore, conductor containing paste layers having an electrostatic electrode pattern shown in FIG. 4 were formed on other green sheets.

Moreover, the conductor containing paste B was filled into the through holes for the plated through holes for connecting external terminals.

At 130 °C and a pressure of 80 kg/cm$^2$, thirty seven green sheets on which no tungsten paste was printed were stacked on the upper side (heating surface) of the green sheet that had been subjected to the above-mentioned processing, and simultaneously the same thirteen green sheets were stacked on the lower side of the green sheet.

(4) Next, the resultant lamination was heated at 600 °C in the atmosphere of nitrogen gas for 1 hour and hot-pressed at 1890 °C and a pressure of 150 kg/cm$^2$ for 3 hours to obtain an aluminum nitride plate 3 mm in thickness, which contained 810 ppm of carbon. This was cut off into a disk 230 mm in diameter to prepare a ceramic plate having therein heating elements and electrostatic electrodes having a thickness of 6 μm and a width of 10 mm.

(5) Next, the plate obtained in the (4) was polished with a diamond grindstone. Subsequently a mask was put thereon, and bottomed holes (diameter: 1.2 mm, and depth: 2.0 mm) for thermocouples were formed on the surface by blast treatment with SiC or the like.

(6) Furthermore, the through holes for the plated through holes were hollowed out to make concaves. Brazing gold made of Ni-Au was heated and allowed to reflow at 700 °C to connect external terminals made of koval to the concaves.

About the connection of the external terminals, a structure wherein a support of tungsten is supported at three points is desirable. This is because the reliability of the connection can be kept.

(7) Next, thermocouples for controlling temperature were buried in the bottomed holes to finish the production of a ceramic heater with an electrostatic chuck.

The thus produced heater with the wafer prober has a brightness N of 3.5 to give a larger radiant heat amount. The heater is also superior in the capability of covering up the inside guard electrodes and ground electrodes.

A drop in the volume resistivity can be suppressed at high temperature. A short circuit and a leakage current are not generated in operation. In the present Example 5, a leakage current was below 10 mA at 400 °C and with a voltage of 1 kV.

(Example 6)

(1) The following were mixed and then the mixture was put into a mold to prepare a formed body: 100 parts by weight of aluminum nitride powder (made by Tokuyama Corp., average particle diameter: 1.1 μm) , 4 parts by weight of yttrium oxide (Y$_2$O$_3$: yttria, average particle diameter: 0.4 μm), and 10 parts by weight of an acrylic resin binder (made by Mitsui Chemicals, Inc, trade name: SA-545, acid value: 1.0 KOHmg/g).

(2) The formed body was heated at 350 °C in the atmosphere of nitrogen for 4 hours to decompose the acrylic resin binder thermally.

(3) The formed body was hot-pressed under conditions of 1890 °C and a pressure of 150 kg/cm$^2$ for 3 hours to obtain an aluminum nitride sintered body.

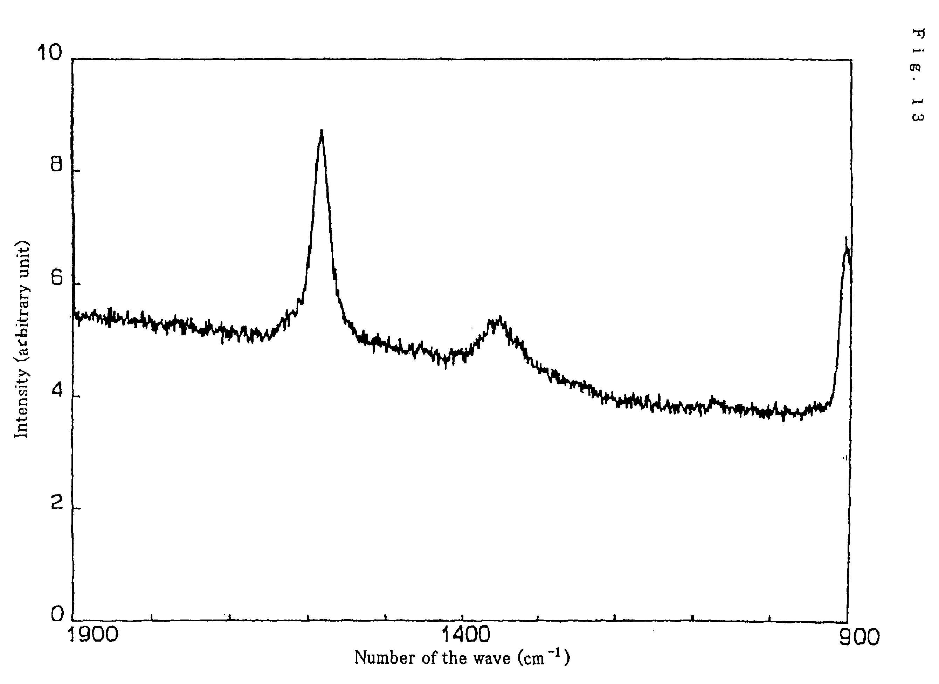

According to laser Raman spectral analysis of carbon of the aluminum nitride sintered body obtained in the present Example 6, the peak intensity ratio I(1580)/I(1355) was 4.0 and the half-width of the peak at 1355 cm$^{-1}$ was 45 cm$^{-1}$ (see FIG. 13).

The fracture toughness of the aluminum nitride sintered bodies of Examples 1 and 6 were measured.

About the fracture roughness, an indentator was pressed against the surface, using a Vickers hardness meter (made by Akashi Seisaku-sho, MVK-D type) and the length of a generated crack was measured. For this, the following calculation equation (6) was used to calculate the fracture toughness

$$\text{fracture toughness} = 0.026 \times E^{1/2} \times 0.5 \times P^{1/2} \times a \times C^{-3/2} \tag{6}$$

In the calculating equation (6), E is Young's modulus (3.18 × 10$^{11}$ Pa), P is a pressing load (98 N), a is the half (m) of the average length of diagonal lines of an indentation, and C is the half (m) of the average of lengths of the crack.

The fracture toughness was 3.4 MPam1/2 in Example 6, and it was 2.8 MPam$^{1/2}$ in Example 1.

(Example 7)

(1) The following were mixed and then the mixture was put into a mold to prepare a formed body: 100 parts by weight of aluminum nitride powder (made by Tokuyama Corp., average particle diameter: 1.1 μm)., 4 parts by weight of yttrium oxide ($Y_2O_3$: yttria, average particle diameter: 0.4 μm), and 12 parts by weight of an acrylic resin binder (made by Mitsui Chemicals, Inc, SA-545, acid value: 0.5 KOHmg/g).
(2) The formed body was heated at 350 °C in the atmosphere of nitrogen for 4 hours to decompose the acrylic resin binder thermally.
(3) The formed body was hot-pressed under conditions of 1890 °C and a pressure of 150 kg/cm$^2$ for 3 hours to obtain an aluminum nitride sintered body.

The carbon content in the sintered body was measured in the same way as in Example 1. As a result of this measurement, the content of carbon contained in the aluminum nitride sintered body was 800 ppm. The brightness N thereof was 3.5.

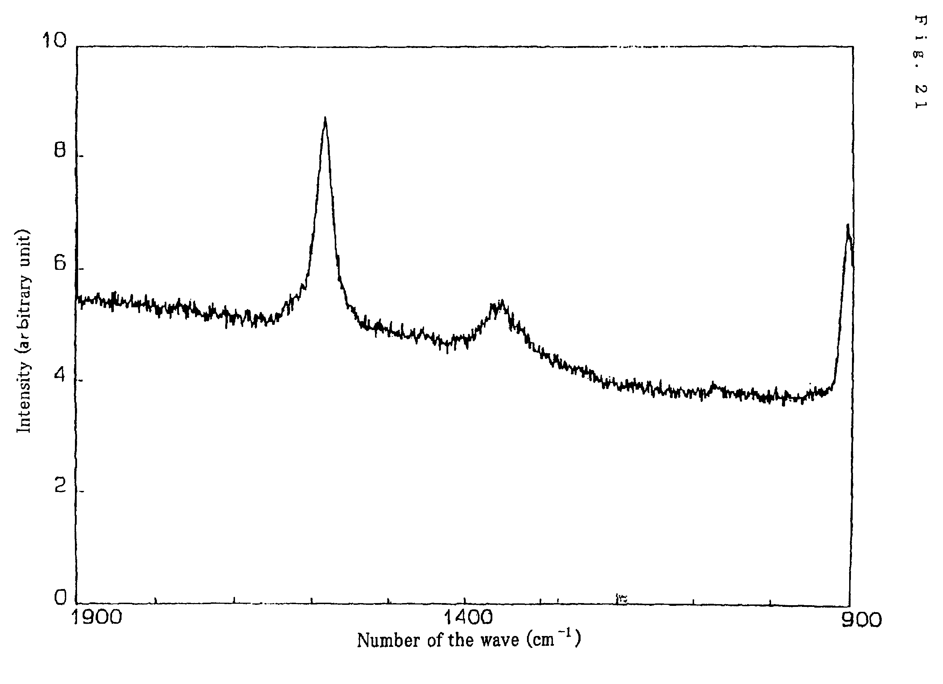

FIG. 21 is a laser Raman spectrum showing the result of laser Raman spectral analysis of the sintered body obtained in the present Example 7. Conditions for the measurement was the same as in Example 1.
As is evident from the laser Raman spectrum shown in FIG. 21, peaks were clearly observed near 1580 cm$^{-1}$ and near 1355 cm$^{-1}$, and the present carbon was carbon with lowered crystallinity. The peak intensity ratio I(1580)/I(1355) was 4.0 and the half-width of the peak at 1355 cm$^{-1}$ was 70 cm$^{-1}$.

(Example 8)

(1) The following were mixed and then the mixture was put into a mold to prepare a formed body: 100 parts by weight of aluminum nitride powder (made by Tokuyama Corp., average particle diameter: 1.1 μm), 4 parts by weight of yttrium oxide ($Y_2O_3$: yttria, average particle diameter: 0.4 μm), and 10 parts by weight of an acrylic resin binder (made by Mitsui Chemicals, Inc, SA-545, acid value: 1.0 KOHmg/g).
(2) The formed body was heated at 600 °C in the atmosphere of nitrogen for 1 hour to decompose the acrylic resin binder thermally.
(3) The formed body was hot-pressed under conditions of 1890 °C and a pressure of 150 kg/cm$^2$ for 3 hours to obtain an aluminum nitride sintered body.

The carbon content in the sintered body was measured in the same way as in Example 1. As a result of the measurement by this method, the content of carbon contained in the aluminum nitride sintered body was 810 ppm. The brightness N thereof was 3.5.

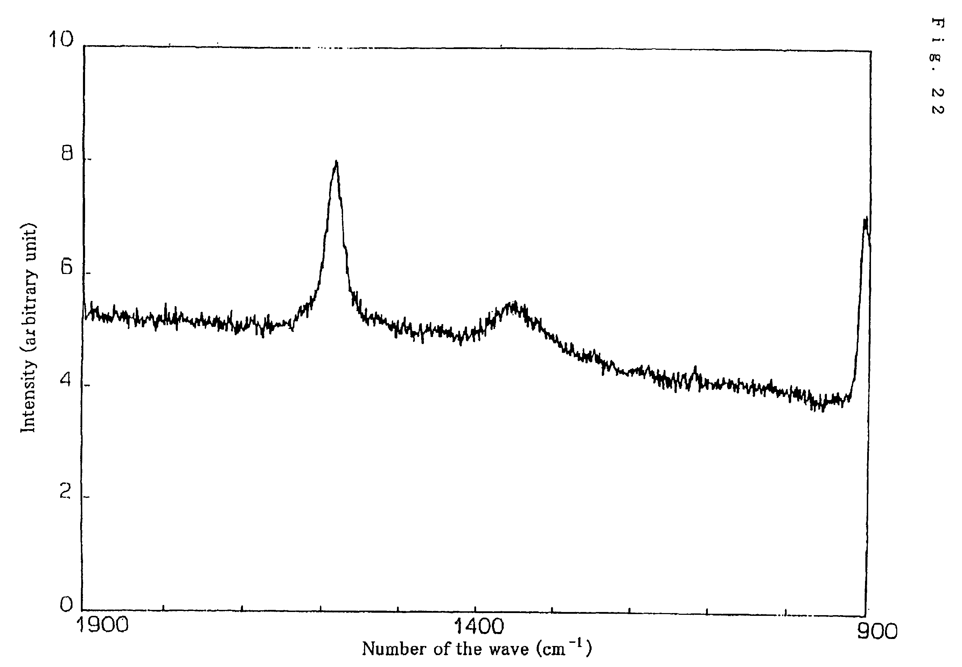

FIG. 22 is a laser Raman spectrum showing the result of laser Raman spectral analysis of the sintered body obtained in the present Example 8. Conditions for the measurement were the same as in Example 1.
As is evident from the laser Raman spectrum shown in FIG. 22, peaks were clearly observed near 1580 cm$^{-1}$ and near 1355 cm$^{-1}$, and a part of crystal was broken to become amorphous although crystal system was kept. The peak intensity ratio I(1580)/I(1355) was 3.8 and the half-width of the peak at 1355 cm$^{-1}$ was 45 cm$^{-1}$.

(Example 9)

(1) The following were mixed and then the mixture was put into a mold to prepare a formed body: 100 parts by weight of aluminum nitride powder (made by Tokuyama Corp., average particle diameter: 1.1 μm), and 8 parts by weight of an acrylic resin binder (made by Kyoeisyha Chemical Co., Ltd., trade name: KC-600, acid value: 17 KOHmg/g).
(2) The formed body was heated at 600 °C in the atmosphere of nitrogen for 1 hour to decompose the acrylic resin binder thermally.
(3) The formed body was hot-pressed under conditions of 1890 °C and a pressure of 150 kg/cm$^2$ for 3 hours to obtain an aluminum nitride sintered body.

The carbon content in the resultant aluminum nitride sintered body was 805 ppm. The brightness N thereof was 3.5.

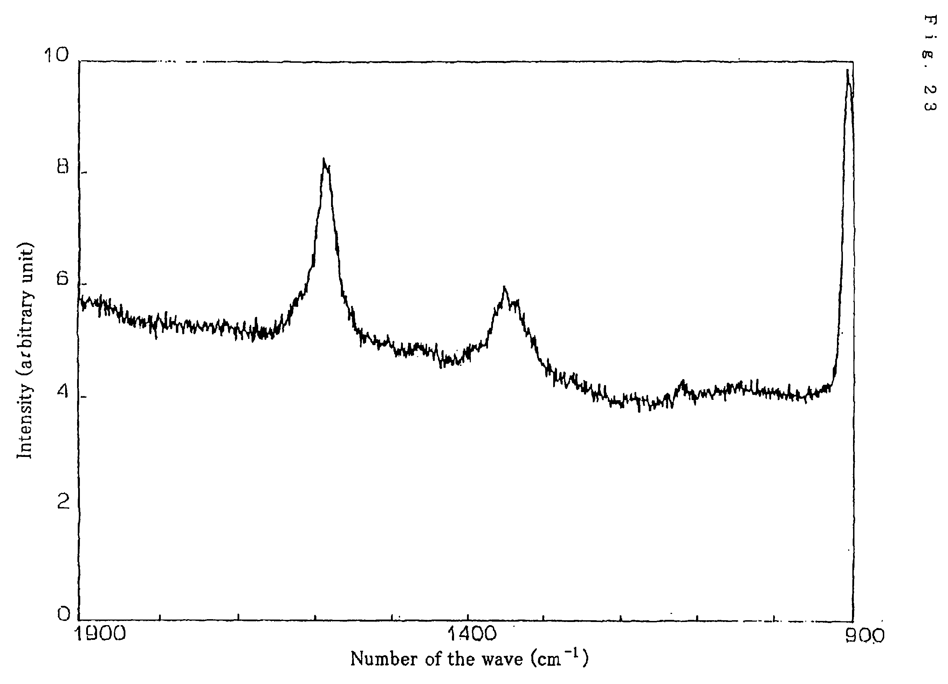

FIG. 23 is a laser Raman spectrum showing the result of laser Raman spectral analysis of the sintered body obtained in the present Example 9. Conditions for the measurement were the same as in Example 1.

On the basis of the laser Raman spectrum shown in FIG. 23, the heights of peaks near 1580 cm$^{-1}$ and near 1355 cm$^{-1}$ were measured to obtain the peak intensity ratio I(1580)/I(1355) The ratio was 2.1. The half-width (full width at half maximum) of the peak at 1355 cm$^{-1}$ was measured and it was 45 cm$^{-1}$. Therefore, the greater part of the sintered body of Example 9 was amorphous carbon.

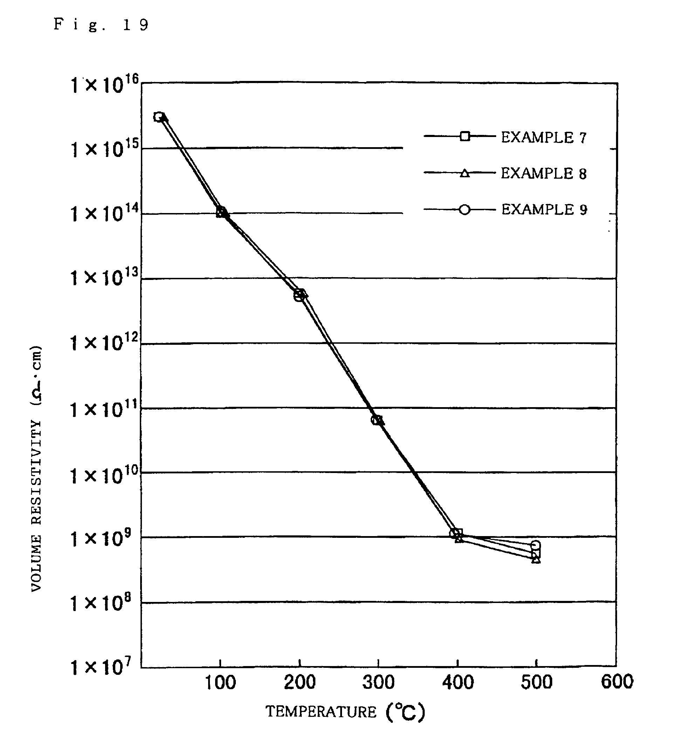

FIG. 19 shows transition in the volume resistivities from room temperature to 500 °C on Examples 7, 8 and 9. As shown in FIG. 19, the aluminum nitride sintered bodies obtained in Examples 7, 8 and 9 had a volume resistivity at 500 °C of $1 \times 10^8$ Ω • cm or more.

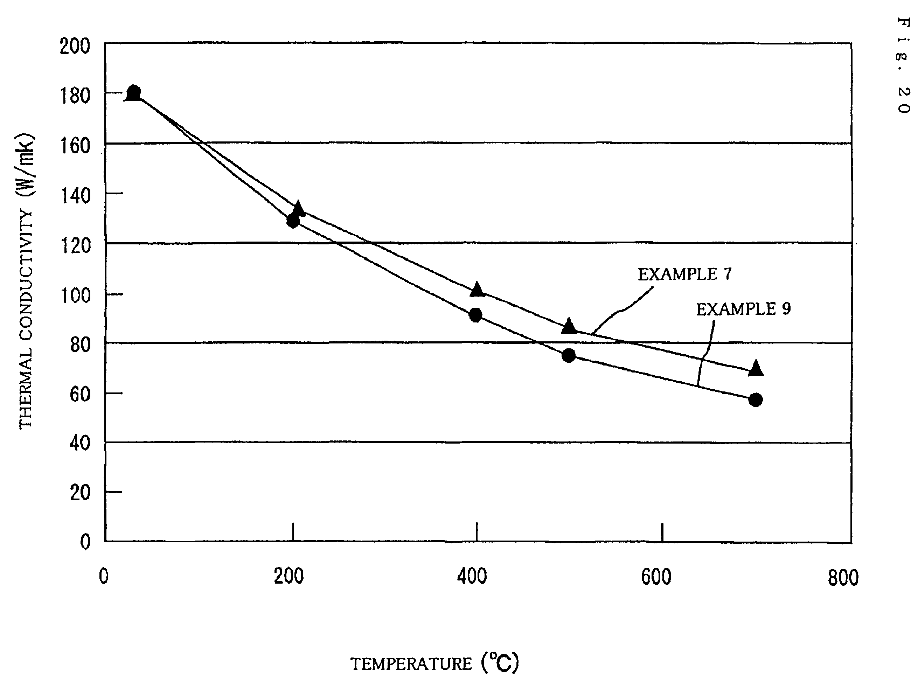

FIG. 20 is showing the dependency of the thermal conductivity of the sintered body upon temperature. In the example comprising carbon whose peak intensity ratio I(1580)/I(1355) was 2.1, indicated as the present Example 9, its thermal conductivity at 700 °C was lowered to 60 W/m • k.

Also, the sintered bodies of Examples 7 and 8 were heated up to 500 °C on a hot plate, their surface temperatures were measured with a thermoviewer (made by Japan Datum Inc., IR162012-0012) and a K type thermocouple according to JIS C 1602 (1980) to examine the difference of the measured temperatures of the two. It can be said that as a gap between the temperature measured with the thermocouple and that measured with the thermoviewer is larger, the temperature error with the thermoviewer is larger.

The results are as follows: a temperature difference was 0.8 °C in Example 7; a temperature difference was 0.9 °C in Example 8; and a temperature difference was 0.9 in Example 9.

The fracture toughness of the aluminum nitride sintered bodies of Examples 7, 8 and 9 and Comparative Examples 1 and 2 was measured. The results are shown in Table 1.

Table 1

|  | Fracture toughness (MPam$^{1/2}$) |
| --- | --- |
| Example 7 | 3.1 |
| Example 8 | 3.4 |
| Example 9 | 2.4 |
| Comparative Example 1 | 3.0 |
| Comparative Example 2 | 2.8 |

(Example 10) Application Example, wafer prober (FIGs. 17 and 18)

(1) A composition obtained by mixing the following was used and formed by the doctor blade method to obtain a green sheet 30 having a thickness of 0.47 mm: 100 parts by weight of aluminum nitride powder (made by Tokuyama Corp., average particle diameter: 1.1 μm), 4 parts by weight of yttria (average particle diameter: 0.4 μm) , 10 parts by weight of an acrylic resin binder (Mitsui Chemicals, Inc, SA-545, acid value: 1.0 KOHmg/g) , and 53 % by weight of alcohol consisting of 1-butanol and ethanol.

(2) This green sheet 30 was dried at 80 °C for 5 hours, and punched to form through holes for plated through holes, for connecting heating elements and external terminal pins.

(3) A conductor containing paste A was prepared by mixing 100 parts by weight of tungsten carbide particles having an average particle diameter of 1 μm, 3.0 parts by weight of an acrylic binder, 3.5 parts by weight of α-terpineol solvent, and 0.3 part by weight of a dispersant. A conductor containing paste B was also prepared by mixing 100 parts by weight of tungsten particles having an average particle diameter of 3 μm, 1.9 parts by weight of an acrylic binder, 3.7 parts by weight of α-terpineol solvent, and 0.2 part by weight of a dispersant.

(4) The conductor containing paste A was printed on the surface of the green sheet 30 by screen printing, so as to form a printed layer 50 for guard electrodes and a printed layer 60 for ground electrodes in a lattice form.

The conductor containing paste B was filled into the through holes for plated through holes, for connecting external terminal pins, to make filled layers 160 and 170 for the plated through holes.

The green sheets 30 on which the conductor containing paste was printed and green sheets 30' on which no conductor containing paste was printed, the number of those was 50, were laminated and then the sheets were integrated with each other at 130 °C and a pressure of 80 kgf/cm$^2$ (see FIG. 17(a)).

(5) The lamination resulting from the integration was thermally decomposed at 600 °C for 1 hour, and was then hot-pressed under conditions of 1890 °C and a pressure of 150 kg/cm$^2$ for 3 hours, to obtain an aluminum nitride plate having a thickness of 3 mm. This plate was cut off into a disk 230 mm in diameter to prepare an aluminum nitride substrate 3 (FIG. 17 (b)). About the size of plated through holes 16 and 17, their diameter was 0.2 mm and their depth was 0.2 mm. The thickness of guard electrodes 5 and ground electrodes 6 was 10 µm. The positions where the guard electrodes 5 were formed were 1 mm apart from the heating elements along the thickness direction of the sintered body. The positions where the ground electrodes 6 were formed were 1.2 mm apart from a chuck face 1a along the thickness direction of the sintered body.

(6) The aluminum nitride substrate 3 obtained in the (5) was polished with a diamond grindstone. Subsequently a mask was put thereon, and concaves (not illustrated) for thermocouples and grooves 7 (width: 0.5 mm, and depth: 0.5 mm) for adsorbing a semiconductor wafer were formed on the surface by blast treatment with glass beads (FIG. 17(c)).

(7) Furthermore, a conductor containing paste was printed on the back surface opposite to the chuck face 1a on which the grooves 7 were formed, so as to form a paste layer for heating elements. The used conductor containing paste was Solvest PS603D made by Tokuriki Kagaku Kenkyu-zyo, which is used to form plated through holes in printed circuit boards. Namely, this paste was a silver/lead paste, and contained metal oxides consisting of lead oxide, zinc oxide, silica, boron oxide and alumina (the weight ratio thereof was 5/55/10/25/5), in an amount of 7.5 % by weight of silver.

The used silver in the conductor containing paste was scaly particles having an average particle diameter of 4.5 µm.

(8) The aluminum nitride substrate (heater plate) 3, in which the conductor containing paste was printed on its back surface to form the heating elements 41, was heated and fired at 780 °C to sinter silver and lead in the conductor containing paste and further bake them on the aluminum nitride substrate 3. Thus, the heating elements 41 were formed (FIG. 17 (d)). Next, this aluminum nitride substrate 3 was immersed in a bath for electroless nickel plating consisting of an aqueous solution containing 30 g/L of nickel sulfate, 30 g/L of boric acid, 30 g/L of ammonium chloride, and 60 g/L of a Rochelle salt, to precipitate a nickel layer 410 having a thickness of 1 µm and a boron content of 1 % or less by weight on the surface of the heating elements 41 which is made from the conductor containing paste. Thus, the thickness of the heating elements 41 was made larger. Thereafter, the aluminum nitride substrate was annealed at 120 °C for 3 hours.

The thus obtained elements 41 comprising the nickel layer 410 had a thickness of 5 µm, a width of 2.4 mm and a area resistivity of 7.7 mΩ/□.

(9) By sputtering, a Ti layer, a Mo layer and a Ni layer were successively formed on the chuck face 1a in which the grooves 7 were formed. The used equipment for this sputtering was SV-4540 made by ULVAC Japan, Ltd. About conditions for the sputtering, air pressure was 0.6 Pa, temperature was 100 °C, electric power was 200 W, and process time was from 30 seconds to 1 minute. Sputtering time was adjusted according to the respective metals to be sputtered.

About the resultant films, an image from a fluorescent X-ray analyzer demonstrated that the thickness of Ti was 0.3 µm, that of Mo was 2 µm and that of Ni was 1 µm.

(10) The aluminum nitride substrate 3 obtained in the step (9) was immersed in a bath for electroless nickel plating consisting of an aqueous solution containing of 30 g/L of nickel sulfate, 30 g/L of boric acid, 30 g/L of ammonium chloride, and 60 g/L of a Rochelle salt to precipitate a nickel layer (thickness: 7 µm) having a boron content of 1 % or less by weight on the surface of the grooves 7 formed in the chuck face 1a. Thereafter, the aluminum nitride substrate was annealed at 120 °C for 3 hours.

The aluminum nitride substrate was immersed in an electroless gold plating solution containing 2 g/L of potassium gold cyanide, 75 g/L of ammonium chloride, 50 g/L of sodium citrate, and 10 g/L of sodium hypophosphite at 93 °C for 1 minute, to form a gold plating layer 1 µm in thickness on the nickel plating layer at the chuck face side of the aluminum nitride substrate 3. Thus, a chuck top conductor layer 2 was formed (see FIG. 18(e)).

(11) Next, air suction holes 8 piercing the back surface from the grooves 7 were formed by drilling, and then blind holes 180 for exposing plated through holes 16 and 17 were formed (see FIG. 18 (f)) . Brazing gold made of Ni-Au (Au: 81.5% by weight, Ni: 18.4% by weight, and impurities: 0.1% by weight) was heated and allowed to reflow at 970 °C so as to connect external terminal pins 19 and 190 made of koval to the blind holes 180 (see FIG. 18 (g)). An external terminal pin 191 made of koval was also attached through a solder (tin 9/lead 1) on the heating elements 41.

(12) Thermocouples for controlling temperature were buried (which is not illustrated) in the concaves, so as to obtain a heater with a wafer prober.

(13) Thereafter, the heater with the wafer prober is usually fixed to a support stand made of stainless steel through a heat insulator made of ceramic fiber (made by Ibiden Co., Ltd., trade name: Ibiwool). A jet nozzle for jetting cooling gas is made in the support stand to adjust the temperature of the wafer prober.

In the heater with the wafer prober, air is sucked from air suction holes 8 to adsorb and hold a semiconductor wafer put on the heater.

The thus produced heater with the wafer prober has a brightness N of 3.5 to give a larger radiant heat amount. The heater is also superior in the capability of covering up the guard electrodes 5 and the ground electrodes 6.

A drop in the volume resistivity can be suppressed at high temperature, and no short circuit is caused in operation. A leakage current can also be reduced.

(Example 11) Application Example, ceramic heater having therein heating elements and electrostatic electrodes for an electrostatic chuck

(1) The following paste was used to conduct formation by the blade method to obtain a green sheet of 0.47 mm in thickness: a paste obtained by mixing 100 parts by weight of aluminum nitride powder (made by Tokuyama Corp., average particle diameter: 1.1 $\mu$m), 4 parts by weight of yttria (average particle diameter: 0.4 $\mu$m), 10 parts by weight of an acrylic resin binder (made by Mitsui Chemicals, Inc, SA-545, acid value: 1.0 KOHmg/g) and 53 parts by weight of mixed alcohols of 1-butanol and ethanol.

(2) Next, this green sheet was dried at 80 °C for 5 hours, and subsequently the following portions were formed by punching: portions which would be through holes through which semiconductor wafer supporting pins of 1.8 mm, 3.0 mm and 5.0 mm in diameter were inserted; and portions which would be plated through holes for connecting external terminal pins.

(3) The following were mixed to prepare a conductor containing paste A: 100 parts by weight of tungsten carbide particles having an average particle diameter of 1 $\mu$m, 3.0 parts by weight of an acrylic binder, 3.5 parts by weight of $\alpha$-terpineol solvent, and 0.3 part by weight of a dispersant.

The following were mixed to prepare a conductor containing paste B: 100 parts by weight of tungsten particles having an average particle diameter of 3 $\mu$m, 1.9 parts by weight of an acrylic binder, 3.7 parts by weight of $\alpha$-terpineol solvent, and 0.2 part by weight of a dispersant.

This conductor containing paste A was printed on the green sheet by screen printing, to form a conductor containing paste layer. The pattern of the printing was made into a concentric pattern. Furthermore, conductor containing paste layers having an electrostatic electrode pattern shown in FIG. 7 were formed on other green sheets.

Moreover, the conductor containing paste B was filled into the through holes for the plated through holes for connecting external terminals.

At 130 °C and a pressure of 80 kg/cm$^2$, thirty seven green sheets on which no tungsten paste was printed were stacked on the upper side (heating surface) of the green sheet that had been subjected to the above-mentioned processing, and simultaneously the same thirteen green sheets were stacked on the lower side of the green sheet.

(4) Next, the resultant lamination was heated at 350 °C in the atmosphere of nitrogen gas for 4 hours and hot-pressed at 1890 °C and a pressure of 150 kg/cm$^2$ for 3 hours to obtain an aluminum nitride plate 3 mm in thickness. This was cut off into a disk of 230 mm in diameter to prepare an aluminum nitride plate having therein heating elements and electrostatic electrodes having a thickness of 6 $\mu$m and a width of 10 mm.

(5) Next, the plate obtained in the (4) was polished with a diamond grindstone. Subsequently a mask was put thereon, and bottomed holes (diameter: 1.2 mm, and depth: 2.0 mm) for thermocouples were formed in the surface by blast treatment with SiC or the like.

(6) Furthermore, the through holes for the plated through holes were hollowed out to make concaves. Brazing gold made of Ni-Au was heated and allowed to reflow at 700 °C to connect external terminals made of koval to the concaves.

About the connection of the external terminals, a structure wherein a support of tungsten is supported at three points is desirable. This is because the reliability of the connection can be kept.

(7) Next, thermocouples for controlling temperature were buried in the bottomed holes to finish the production of a ceramic heater with an electrostatic chuck.

The thus produced heater with the electrostatic chuck has a brightness N of 3.5 to give a larger radiant heat amount. Its thermal conductivity is also high. Moreover, the heater is also superior in the capability of covering up the inside resistance heating elements and electrostatic electrodes.

A drop in the volume resistivity can be suppressed at high temperature. A short circuit and a leakage current are not generated in operation. In the present Example 11, a leakage current was below 10 mA at 400 °C and with a voltage of 1 kV.

(Example 12)

(1) An aluminum nitride sintered body was first produced in the same way as in Example 1. Next, a conductor containing paste was printed on the bottom surface of this aluminum nitride sintered body by screen printing. The pattern of the printing was made to a pattern of concentric circles as shown in FIG. 7.

The used conductor containing paste was Solvest PS603D made by Tokuriki Kagaku Kenkyu-zyo, which is used to form plated through holes in printed circuit boards.

This conductor containing paste was a silver-lead paste and contained 7.5 parts by weight of oxides made of lead oxide (5% by weight), zinc oxide (55% by weight), silica (10% by weight), boron oxide (25% by weight) and alumina (5% by weight) per 100 parts by weight of silver. The silver particles had an average particle diameter of 4.5 μm, and were scaly.

(2) Next, the sintered body on which the conductor containing paste was printed was heated and fired at 780 °C to sinter silver and lead in the conductor containing paste and bake them onto the sintered body. Thus, heating elements 92 were formed. The silver-lead heating elements 92 had a thickness of 5 μm, a width of 2.4 mm and a area resistivity of 7.7 mΩ/□.

(3) The sintered body formed in the step (2) was immersed into an electroless nickel plating bath consisting of an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer 92a (nickel layer) having a thickness of 1 μm on the surface of the silver-lead heating elements 92.

(4) By screen printing, a silver-lead solder paste (made by Tanaka Kikinzoku Kogyo CO.) was printed on portions to which the external terminal pins 93 for attaining connection to a power source would be attached, to form a solder layer. Next, the external terminal pins 93 made of koval were put on the solder layer and heated and the solder layer was allowed to reflow at 420 °C to attach the external terminal pins 93 onto the surface of the heating elements 92.

(5) Thermocouples for controlling temperature were inserted into the bottomed holes, and polyimide was filled into the holes. The polyimide was cured at 190 °C for 2 hours to obtain a ceramic heater 90 (FIG. 7).

(Example 13)

An aluminum nitride sintered body was first produced in the same way as in Example 2. Next, a pattern of heating elements was formed on this aluminum nitride sintered body in the same way as in Example 12, to obtain a ceramic heater.

(Example 14)

An aluminum nitride sintered body was first produced in the same way as in Example 3. Next, a pattern of heating elements was formed on this aluminum nitride sintered body in the same way as in Example 12, to obtain a ceramic heater.

(Example 15)

(1) The following were mixed and then the mixture was put into a mold to prepare a formed body: 45 parts by weight of silicon nitride power (average particle diameter: 1.1 μm), yttrium oxide ($Y_2O_3$: yttria, average particle diameter: 0.4 μm), 15 parts by weight of $AlO_3$ (average particle diameter: 0.5 μm), 20 parts by weight of $SiO_2$ (average particle diameter: 0.5 μm) and 8 parts by weight of an acrylic resin binder (made by Kyoeisyha Chemical Co., Ltd., trade name: KC-600, acid value: 10 KOHmg/g).

(2) The formed body was heated at 350 °C in the atmosphere of nitrogen for 4 hours to decompose the acrylic resin binder thermally.

(3) The formed body was hot-pressed under conditions of 1600 °C and a pressure of 150 kg/cm$^2$ for 3 hours to obtain an silicon nitride sintered body.

The carbon content in the silicon nitride sintered body was 800 ppm. The brightness N thereof was 3.5.

A pattern of heating elements was formed on this sintered body in the same way as in Example 12, to obtain a ceramic heater.

According to laser Raman spectral analysis of carbon in the silicon nitride sintered body obtained in the present Example 15, the peak intensity ratio I(1580)/I(1355) was 2.3 and the half-width of the peak at 1355 $cm^{-1}$ was 45 $cm^{-1}$.

(Comparative Example 3)

An aluminum nitride sintered body was first produced in the same way as in Comparative Example 1. Next, a pattern of heating elements was formed on this aluminum nitride sintered body in the same way as in Example 12, to obtain a ceramic heater.

(Comparative Example 4)

An aluminum nitride sintered body was first produced.in the same way as in Comparative Example 2. Next, a pattern of heating elements was formed on this aluminum nitride sintered body in the same way as in Example 12, to obtain a ceramic heater.

(Comparative Example 5)

(1) The following were mixed and then the mixture was put into a mold to prepare a formed body: 45 parts by weight of silicon nitride power (average particle diameter: 1.1 μm), yttrium oxide ($Y_2O_3$: yttria, average particle diameter: 0.4 μm), 15parts by weight of $Al_2O_3$ (average particle diameter: 0.5 μm) 20 parts by weight of $SiO_2$; (average particle diameter: 0.5 μm) and 0.10 part by weight of crystalline graphite (made by Toyo Tanso Inc, GR-1200).

(2) The formed body was hot-pressed under conditions of 1600 °C and a pressure of 150 $kg/cm^2$ for 3 hours to obtain a silicon nitride sintered body.

The carbon content in the silicon nitride sintered body was 800 ppm. The brightness N thereof was 3.5.

A pattern of heating elements was formed on this silicon nitride sintered body in the same way as in Example 12.

According to laser Raman spectral analysis of carbon in the silicon nitride sintered body, a peak was observed only at 1580 $cm^{-1}$.

On the ceramic heaters obtained in Example 15 and Comparative Example 5, relationship between temperature thereof and volume resistivity thereof is shown in Table 2.

Table 2

|  | Temperature (°C) | Volume resistivity $\Omega \cdot cm$ |
|---|---|---|
| Example 14 | 25 | $1 \times 10^{16}$ |
|  | 100 | $2 \times 10^{15}$ |
|  | 200 | $1 \times 10^{14}$ |
|  | 300 | $3 \times 10^{13}$ |
|  | 400 | $1 \times 10^{12}$ |
|  | 500 | $1 \times 10^{11}$ |
| Example 15 | 25 | $1 \times 10^{16}$ |
|  | 100 | $1 \times 10^{15}$ |
|  | 200 | $8 \times 10^{13}$ |
|  | 300 | $5 \times 10^{12}$ |
|  | 400 | $1 \times 10^{11}$ |
|  | 500 | $1 \times 10^{11}$ |

In the above-mentioned measurement, the volume resistivity and thermal conductivity were measured in the same way as in Example 1.

The sintered bodies of Examples 12 to 15 and Comparative Examples 3 to 5 were heated up to 500 °C on a hot plate, their surface temperatures were measured with a thermoviewer (made by Japan Datum Inc., IR162012-0012) and a K type thermocouple according to JIS C 1602 (1980) to examine the difference of the 'measured temperatures of the two. It can be said that as a gap between the temperature measured with the thermocouple arid that measured with the thermoviewer is larger, the temperature error with the thermoviewer is larger.

Results of the measurement are as follows: a temperature difference was 0.8 °C in Example 12; a temperature difference was 0.9 °C in Example 13; a temperature difference was 1.0 °C in Examples 14 and 15; a temperature difference was 0.8 °C in Comparative Example 3; a temperature difference was 8 °C in Comparative Example 4; and a temperature difference was 0.8 °C in Comparative Example 5.

The ceramic heaters obtained in Example 12 to 15 had a brightness N of 3.5, gave a large radiant heat amount, and it was possible to suppress a drop in the volume resistivity at high temperature. Moreover, they were superior in measurement accuracy with the thermoviewer. Furthermore, it was possible that the ceramic heaters of Examples 12, 13 and 15 kept a high thermal conductivity in a high temperature range.

On the other hand, in the ceramic heater obtained in Comparative Example 3, its volume resistivity dropped to $1 \times 10^8 \, \Omega \cdot$ cm or less in a high temperature range (500 °C).

The ceramic heater obtained in Comparative Example 4 had a high brightness N of 7.0, and had a large temperature error resulting from the measurement of thermoviewer as formed in Comparative Example 2 .

(Example 16)

An aluminum nitride sintered body was first produced in the same way as in Example 6. Next, a pattern of heating elements was formed on this aluminum nitride sintered body in the same way as in Example 12, to obtain a ceramic heater.

The fracture toughness of the heaters of Examples 12 and 16 was measured. The fracture toughness was measured in the same way as in Example 1.

The fracture toughness was 2.8 MPam$^{1/2}$ in Example 12, and it was 3.4 MFam$^{1/2}$ in Example 16. The ceramic heater obtained in Example 16 was a ceramic heater having a particularly high fracture toughness.

(Example 17)

(1) An aluminum nitride sintered body was first produced in the same way as in Example 7. Next, a conductor containing paste was printed on the bottom surface of this aluminum nitride sintered body by screen printing. The pattern of the printing was made to a pattern of concentric circles as shown in FIG. 7.

The used conductor containing paste was Solvest PS603D made by Tokuriki Kagaku Kenkyu-zyo, which is used to form plated through holes in printed circuit boards.

This conductor containing paste was a silver-lead paste and contained 7.5 parts by weight of oxides made of lead oxide (5 % by weight) , zinc oxide (55% by weight) , silica (10% by weight) , boron oxide (25% by weight) and alumina (5% by weight) per 100 parts by weight of silver. The silver particles had an average particle diameter of 4.5 μm, and were scaly.

(2) Next, the sintered body on which the conductor containing paste was printed was heated and fired at 780 °C to sinter silver and lead in the conductor containing paste and bake them onto the sintered body. Thus, heating elements 92 were formed. The silver-lead heating elements 92 had a thickness of 5 μm, a width of 2.4 mm and a area resistivity of 7.7 mΩ/□

(3) The sintered body formed in the step (4) was immersed into an electroless nickel plating bath consisting of an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer 92a (nickel layer) having a thickness of 1 μm on the surface of the silver-lead heating elements 92.

(4) By screen printing, a silver-lead solder paste (made by Tanaka Kikinzoku Kogyo CO.) was printed on portions to which external terminals for attaining connection to a power source would be attached, to form a solder layer. Next, the external terminal pins 93 made of koval were put on the solder layer and heated and allowed to reflow at 420 °C to attach the external terminal pins 93 to the surface of the heating elements 92.

(5) Thermocouples for controlling temperature were inserted into the bottomed holes, and polyimide was filled into the holes. The polyimide was cured at 190 °C for 2 hours to obtain a ceramic heater 90 (FIG. 7).

(Example 18)

An aluminum nitride sintered body was first produced in the same way as in Example 8. Next, a pattern of heating elements was formed on this aluminum nitride sintered body in the same way as in Example 17, to obtain a ceramic heater.

(Example 19)

(1) The following were mixed and then the mixture was put into a mold to prepare a formed body: 45 parts by weight of silicon nitride power (average particle diameter: 1.1 $\mu$m), 20 parts by weight of yttrium oxide ($Y_2O_3$: yttria, average particle diameter: 0.4 $\mu$m), 15 parts by weight of $Al_2O_3$ (average particle diameter: 0.5 $\mu$m), 20 parts by weight of $SiO_2$ (average particle diameter: 0.5 $\mu$m) and 8 parts by weight of an acrylic resin binder (made by Mitsui Chemicals, Inc, SA-545, acid value: 1.0 KOHmg/g).
(2) The formed body was heated at 350 °C in the atmosphere of nitrogen for 4 hours to decompose the acrylic resin binder thermally.
(3) The formed body was hot-pressed under conditions of 1600 °C and a pressure of 150 kg/cm$^2$ for 3 hours to obtain a silicon nitride sintered body.

The carbon content in the resultant silicon nitride sintered body was 800 ppm. The brightness N thereof was 3.5.
According to laser Raman spectral analysis of carbon in the aluminum nitride sintered body obtained in the present Example 19, the peak intensity ratio I(1580)/I(1355) was 3.9 and the half-width of the peak at 1355 cm$^{-1}$ was 45 cm$^{-1}$.
A pattern of heating elements was made on this sintered body in the same way as in Example 17.

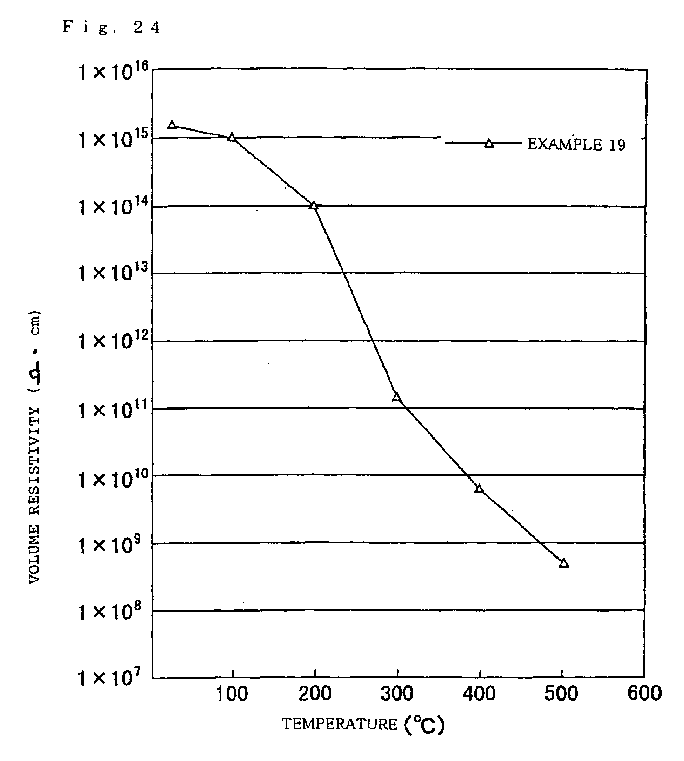

FIG. 24 shows transition in the volume resistivity, from room temperature to 500 °C, of the ceramic substrate (sintered body) in the ceramic heater of Example 19.
As shown in FIG. 24, a volume resistivity of $1 \times 10^8$ $\Omega \cdot$ cm or more was kept in a high temperature range (500 °C).
The ceramic heaters obtained in Examples 17 to 19 were heated up to 500 °C on a hot plate, their surface temperatures were measured with a thermoviewer (made by Japan Datum Inc., IR162012-0012) and a K type thermocouple according to JIS-C-1602 (1980) to examine the difference of the measured temperatures of the two. It can be said that as a gap between the temperature measured with the thermocouple and that measured with the thermoviewer is larger, the temperature error with the thermoviewer is larger.
Results of the measurement are as follows: a temperature difference was 0.8 °C in Example 17; a temperature difference was 0.9 in Example 18; and a temperature difference was 1.0 °C in Example 19.
In the above-mentioned measurement, the volume resistivity and thermal conductivity were measured in the same way as in Example 1.
The ceramic heaters obtained in Example 17 to 19 have a brightness N of 3.5, give a large radiant heat amount, and are superior in measurement accuracy with the thermoviewer. It is possible to suppress a drop in the volume resistivity at high temperature.

(Example 20) Application Example, ceramic heater having therein heating elements and electrostatic electrodes for an electrostatic chuck (FIG. 7)

(1) The following paste was used to conduct formation by the doctor blade method to obtain a green sheet of 0.47 mm in thickness: a paste obtained by mixing 100 parts by weight of aluminum nitride powder (made by Tokuyama Corp., average particle diameter: 1.1 $\mu$m), 4 parts by weight of yttria (average particle diameter: 0.4 $\mu$m), 11.5 parts by weight of an acrylic binder, 0.5 part by weight of a dispersant, 0.2 part by weight of saccharose, 0.05 part by weight of graphite, and 53 parts by weight of mixed alcohols of 1-butanol and ethanol.
(2) Next, this green sheet was dried at 80 °C for 5 hours, and subsequently the following portions were made by punching: portions which would be through holes through which semiconductor wafer supporting pins 1.8 mm, 3.0 mm and 5.0 mm in diameter each were inserted; and portions which would be plated through holes for connecting external terminals.
(3) The following were mixed to prepare a conductor containing paste A: 100 parts by weight of tungsten carbide particles having an average particle diameter of 1 $\mu$m, 3.0 parts by weight of an acrylic binder, 3.5 parts by weight of $\alpha$-terpineol solvent, and 0.3 part by weight of a dispersant.

The following were mixed to prepare a conductor containing paste B: 100 parts by weight of tungsten particles having an average particle diameter of 3 $\mu$m, 1.9 parts by weight of an acrylic binder, 3.7 parts by weight of $\alpha$-terpineol solvent, and 0.2 part by weight of a dispersant.

This conductor containing paste A was printed on the green sheet by screen printing, to form a conductor containing paste layer. The pattern of the printing was made into a concentric pattern. Furthermore, conductor containing paste layers having an electrostatic electrode pattern shown in FIG. 7 were formed on other green sheets.

Moreover, the conductor containing paste B was filled into the through holes for the plated through holes for connecting external terminals.

At 130 °C and a pressure of 80 kg/cm$^2$, thirty seven green sheets on which no tungsten paste was printed were stacked on the upper side (heating surface) of the green sheet which had been processed with the above-mentioned processing, and simultaneously the same thirteen green sheets were stacked on the lower side of the green sheet.

(4) Next, the resultant lamination was degreased at 600 °C in the atmosphere of nitrogen gas for 5 hours and hot-pressed at 1890 °C and a pressure of 150 kg/cm$^2$ for 3 hours to obtain an aluminum nitride plate 3 mm in thickness. This was cut off into a disk of 230 mm in diameter to prepare a ceramic plate having therein heating elements and electrostatic electrodes having a thickness of 6 $\mu$m and a width of 10 mm.

(5) Next, the plate obtained in the (4) was polished with a diamond grindstone. Subsequently a mask was put thereon, and bottomed holes (diameter: 1.2 mm, and depth: 2.0 mm) for thermocouples were formed in the surface by blast treatment with SiC or the like.

(6) Furthermore, the part of through holes for the plated through holes were hollowed out to make concaves. Brazing gold made of Ni-Au was heated and allowed to reflow at 700 °C to connect external terminals made of koval to the concaves.

About the connection of the external terminals, a structure wherein a support of tungsten is supported at three points is desirable. This is because the reliability of the connection can be kept.

(7) Next, thermocouples for controlling temperature were buried in the bottomed holes to finish the production of a ceramic heater with an electrostatic chuck.

The thus produced heater with the electrostatic chuck has a brightness N of 3.5 to give a larger radiant heat amount. The heater'has a high thermal conductivity and is also superior in the capability of covering up the inside guard electrodes and ground electrodes.

A drop in the volume resistivity can be suppressed at high temperature. A short circuit and a leakage current are not generated in operation. In the present Example, a leakage current was below 10 mA at 400 °C and with a voltage of 1 kV.

Industrial Applicability

As described above, the carbon-containing aluminum nitride sintered body of the present invention comprises carbon having a low crystallinity wherein peaks appear near 1580 cm$^{-1}$ and near 1355 cm$^{-1}$ in laser Raman spectral analysis; therefore, the sintered body is an aluminum nitride sintered body having a high volume resistivity at high temperature and a low brightness to make accurate temperature measurement with a thermoviewer possible, and it is useful, for example, for a substrate of a hot plate, an electrostatic chuck, a wafer prober, a susceptor and the like.

In the ceramic substrate for a semiconductor producing/examining device of the present invention, a ceramic made of an aluminum nitride sintered body or the like is used, and which ceramic comprises carbon having a low crystallinity
wherein peaks appear near 1580 cm$^{-1}$ and near 1355 cm$^{-1}$ in laser Raman spectral analysis. Therefore, the ceramic substrate is a ceramic substrate having a high volume resistivity at high temperature and a low brightness to make accurate temperature measurement with a thermoviewer possible, and it is useful, for example, for a hot plate, an electrostatic chuck, a wafer prober, a susceptor and the like.

**Claims**

1. A carbon-containing aluminum nitride sintered body comprising carbon whose peaks appear near 1580cm$^{-1}$ and near 1355 cm$^{-1}$ in laser Raman spectral analysis in a matrix made of aluminum nitride.

2. The carbon-containing aluminum nitride sintered body according to claim 1, comprising the carbon whose peak intensity ratio I(1580)/I(1355) , which is the ratio of the peak near 1580 cm$^{-1}$ to the peak near 1355 cm$^{-1}$, is 3.0 or less.

3. The carbon-containing aluminum nitride sintered body according to claim 1, comprising the carbon whose peak intensity ratio I(1580)/I(1355), which is the ratio of the peak near 1580 cm$^{-1}$ to the peak near 1355 cm$^{-1}$, is over 3.0.

4. The carbon-containing aluminum nitride sintered body according to any of claims 1 to 3, comprising the carbon whose half-width (full width at half maximum) of the peak near 1355 cm$^{-1}$ is 20 cm$^{-1}$ or more.

5. The carbon-containing aluminum nitride sintered body according to any of claims 1 to 4, wherein the content of the carbon is from 200 to 5000 ppm.

6. The carbon-containing aluminum nitride sintered body according to any of claims 1 to 5, wherein said matrix comprises a sintering aid comprising at least one of alkali metal oxides, alkali earth metal oxides and rare element oxides.

7. The carbon-containing aluminum nitride sintered body according to any of claims 1 to 6, wherein the brightness defined in JIS Z 8721 is N4 or less.

8. A ceramic substrate for a semiconductor producing/examining device, wherein the ceramic substrate which is comprising carbon whose peaks appear near 1580cm$^{-1}$ and near 1355 cm$^{-1}$ in laser Raman spectral analysis is equipped with a conductor.

9. The ceramic substrate for the semiconductor producing/examining device according to claim 8, comprising the carbon whose peak intensity ratio I(1580)/I(1355), which is the ratio of the peak near 1580 cm$^{-1}$ to the peak near 1355 cm$^{-1}$, is 3.0 or less.

10. The ceramic substrate for the semiconductor producing/examining device according to claim 8, comprising the carbon whose peak intensity ratio I(1580)/I(1355), which is the ratio of the peak near 1580 cm$^{-1}$ to the peak near 1355 cm$^{-1}$, is over 3.0.

11. The ceramic substrate for the semiconductor producing/examining device according to any of claims 8 to 10, comprising the carbon whose half-width (full width at half maximum) of the peak near 1355 cm$^{-1}$ is 20 cm$^{-1}$ or more.

12. The ceramic substrate for the semiconductor producing/examining device according to any of claims 8 to 11, wherein said conductor is an electrostatic electrode, and the ceramic substrate functions as an electrostatic chuck.

13. The ceramic substrate for the semiconductor producing/examining device according to any of claims 8 to 11, wherein said conductor is a resistance heating element and the ceramic substrate functions as a hot plate.

14. The ceramic substrate for the semiconductor producing/examining device according to any of claims 8 to 11, wherein said conductor is formed on a surface of the ceramic substrate and inside the ceramic substrate, and said inner conductor is at least any one of a guard electrode and/or a ground electrode, and the ceramic substrate functions as a wafer prober.

15. The ceramic substrate for the semiconductor producing/examining device according to any of claims 8 to 14, wherein the content of the carbon is from 200 to 5000 ppm.

16. The ceramic substrate for the semiconductor producing/examining device according to any of claims 8 to 15, wherein the ceramic substrate comprises a sintering aid comprising at least one of alkali metal oxides, alkali earth metal oxides and rare element oxides.

17. The ceramic substrate for the semiconductor producing/examining device according to any of claims 8 to 16, wherein the brightness defined in JIS Z 8721 is N4 or less.

F i g . 1

F i g. 2

Fig. 3

Fig. 4

(a)

CHUCK POSITIVE
22 ELECTROSTATIC LAYER

CHUCK NEGATIVE
23 ELECTROSTATIC LAYER

20 ELECTROSTATIC
CHUCK

22a    11  40 CERAMIC
DIELECTRIC
FILM

9 SILICON
WAFER

11 RESISTANCE HEATING
ELEMENT

23a

(b)

Fig. 5

Fig. 6

Fig. 7

94 BOTTOMED HOLE

94

90 CERAMIC HEATER

95 THROUGH HOLE

92 RESISTANCE HEATING ELEMENT

94

94

94

94

93 TERMINAL PIN

95

94

94

94

91 CERAMIC SUBSTRATE

Fig. 8

90

99 SILICON WAFER

91b WAFER-PUTTING SURFACE

96 SUPPORTING PIN

92    92 a

91

94

91a BOTTOM SURFACE

95

92

92a METAL COVERING LAYER

93

92

92 a    92 a    93

92

Fig. 9

F i g . 1 0

Fig. 11

F i g. 1 2

Fig. 13

EP 1 254 874 A1

Fig. 14

Fig. 15

Fig. 16

Fig. 17

(a)

50    50

30′

160    30

160    30′

170    30

30′

60    60

(b)

1a    5

16    3

17    6

(c)

7   7   7   7   7  5   7

16    5

17    6

(d)

7   7   7  5   7   7   7

16    5

17    6

41   41   41   41   41   41   41

Fig. 18

(e)

(f)

(g)

Fig. 19

Fig. 20

EP 1 254 874 A1

46

Fig. 21

EP 1 254 874 A1

Fig. 22

Fig. 23

Fig. 24

## INTERNATIONAL SEARCH REPORT

International application No.

PCT/JP00/02165

**A. CLASSIFICATION OF SUBJECT MATTER**
Int.Cl$^7$   C04B 35/581

According to International Patent Classification (IPC) or to both national classification and IPC

**B. FIELDS SEARCHED**

Minimum documentation searched (classification system followed by classification symbols)
Int.Cl$^7$   C04B 35/581

Documentation searched other than minimum documentation to the extent that such documents are included in the fields searched
Jitsuyo Shinan Koho          1926-1996     Toroku Jitsuyo Shinan Koho  1994-2000
Kokai Jitsuyo Shinan Koho   1971-2000      Jitsuyo Shinan Toroku Koho  1996-2000

Electronic data base consulted during the international search (name of data base and, where practicable, search terms used)
STN(CA)

**C. DOCUMENTS CONSIDERED TO BE RELEVANT**

| Category* | Citation of document, with indication, where appropriate, of the relevant passages | Relevant to claim No. |
|---|---|---|
| X<br>Y | JP, 60-186479, A2 (Toshiba Corporation),<br>21 September, 1985 (21.09.85),<br>page 2, upper right column, line 5 to lower right column,<br>line 4; table 1   (Family: none) | 1-5,7<br>8-15,17 |
| X<br>Y | US, 4803183, A (Elektroschmelzwerk Kempten GmbH),<br>07 February, 1989 (07.02.89),<br>Columns 10 to 13,<br>& JP, 62-223070, A,<br>page 8, lower left column, line 19 to page 11, lower right<br>column, line 15<br>& EP, 237072, A2    & DE, 3608326, A | 1-5,7<br>8-15,17 |
| X<br>Y | JP, 1-179765, A (Sumitomo Electric Industries, Ltd.),<br>17 July, 1989 (17.07.89),<br>page 3, upper left column, line 8 to upper right column,<br>line 7; table 1   (Family: none) | 1-7<br>8-17 |
| Y<br>A | EP, 757023, A2 (NGK INSULATORS, LTD.),<br>05 February, 1997 (05.02.97),<br>page 2, lines 1 to 37; page 4, lines 20 to 45<br>& JP, 9-48668, A, | 8-17<br>1-7 |

☒  Further documents are listed in the continuation of Box C.          ☐  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 17 July, 2000 (17.07.00) | 25 July, 2000 (25.07.00) |

| Name and mailing address of the ISA/ | Authorized officer |
|---|---|
| Japanese Patent Office | |
| Facsimile No. | Telephone No. |

Form PCT/ISA/210 (second sheet) (July 1992)